# EUROPEAN PATENT APPLICATION

(11) **EP 4 679 978 A1**
(43) Date of publication of application: **14.01.2026**
(21) Application number: 25177665.4
(22) Date of filing: 20.05.2025
(51) Int. Cl.: H10F 39/00

(54) **IMAGE SENSOR, AND MANUFACTURING METHOD OF AN IMAGE SENSOR**

(30) Priority: 08.07.2024 JP 2024109548
(71) Applicant: Samsung Electronics Co., Ltd., Suwon-si, Gyeonggi-do 16677 (KR)
(72) Inventor: INAGAKI, Hiroyuki, Kanagawa, 230-0027 (JP); MINEO, Keitada, Kanagawa, 230-0027 (JP)
(74) Representative: Kuhnen & Wacker Patent- und Rechtsanwaltsbüro PartG mbB

(57) **Abstract**

An image sensor is provided. The image sensor includes: a logic chip including a logic circuit configured to process a signal; and a pixel chip (150) configured to generate the signal. The pixel chip (150) includes: an avalanche photodiode (100); an electrode pad (260); an active pillar (201) having a first end connected to a cathode (120) of the avalanche photodiode (100) and a second end connected to the electrode pad (260); and a vertical gate-all-around transistor (200) having a channel (230) including a portion of the active pillar (201) and a planar gate (240) surrounding the channel (230). The logic chip and the pixel chip (150) are connected through the electrode pad (260).

## Description

### BACKGROUND

### 1. Field

The present disclosure relates to an image sensor, and a manufacturing method of an image sensor.

### 2. Description of Related Art

A single-photon avalanche diode (SPAD) amplifies a charge generated by photoelectric conversion of incident light through avalanche amplification and outputs the charge as an electric signal. The SPAD is a photon counting sensor that can detect light particles one by one, has extremely high temporal resolution, and counts incident photons one by one for each pixel. The SPAD enables noise-free readout with a high dynamic range.

Each pixel of the image sensor includes a photodiode, such as a SPAD, and a logic circuit that processes the signal generated by the photodiode.

A related image sensor includes a plurality of photodiodes arranged on a substrate, a plurality of active pillars connected to the photodiode and extending in a vertical direction to a lower surface the substrate, at least two transistors that utilize a portion of the active pillar as a channel region and are stacked in the vertical direction, and a floating diffusion region arranged below a transfer transistor, which is an uppermost transistor, and through which charge is transferred from the photodiodes through the transfer transistor and a portion of the active pillars.

A related light-receiving element is formed by laminating a first substrate on which an avalanche photodiode and a polysilicon thin-film transistor (TFT) forming a clamp circuit connected to a cathode of the avalanche photodiode are formed, and a second substrate having a metal-oxide-semiconductor field-effect transistor (MOSFET) forming a quench resistor, and an inverter, each of which is connected to a polysilicon TFT.

### SUMMARY

However, in the related image sensor, all transistors included in the pixel circuit are formed on a substrate on which a photodiode is formed. When the pixel circuit is configured with a plurality of transistors having different threshold voltages, the power supply voltage cannot be lowered because it is limited to transistors with high thresholds, thereby increasing power consumption. In addition, the light-receiving element in the related image sensor has an increased size because the pixel size is limited by the layout space of the polysilicon TFT, which is a planar transistor.

One or more example embodiments provide an image sensor and a manufacturing method of the image sensor that realize low power consumption and small area.

According to an aspect of an example embodiment, an image sensor includes: a logic chip including a logic circuit configured to process a signal; and a pixel chip configured to generate the signal. The pixel chip includes: an avalanche photodiode; an electrode pad; an active pillar having a first end connected to a cathode of the avalanche photodiode and a second end connected to the electrode pad; and a vertical gate-all-around transistor having a channel including a portion of the active pillar and a planar gate surrounding the channel. The logic chip and the pixel chip are connected through the electrode pad.

According to another aspect of an example embodiment, an image sensor includes: a logic chip including a logic circuit configured to process a signal; and a pixel chip configured to generate the signal. The pixel chip includes: an avalanche photodiode; an electrode pad; an active pillar having a first end connected to a cathode of the avalanche photodiode and a second end connected to the electrode pad; a first gate-all-around transistor having a first channel including a first portion of the active pillar and a first planar gate surrounding the first channel; and a second gate-all-around transistor connected in series with the first gate-all-around transistor, and having a second channel including a second portion of the active pillar and a second planar gate surrounding the first channel.

According to another aspect of an example embodiment, a manufacturing method of an image sensor includes: providing a pixel chip including a substrate and an avalanche photodiode; forming a laminated film including a first sacrificial layer, a gate layer, and a second sacrificial layer, on the substrate of the pixel chip; forming a hole penetrating the laminated film to expose a cathode of the avalanche photodiode; forming a gate oxide layer on a side wall of the hole; forming an active pillar within the hole that is connected to the cathode of the avalanche photodiode; removing the first sacrificial layer and the second sacrificial layer to expose a portion of the gate oxide layer; exposing a portion of the active pillar by removing the portion of the gate oxide layer; and forming a diffusion layer on the portion of the active pillar to form a vertical gate-all-around transistor having a channel including a portion of the active pillar and a planar gate surrounding the channel, the active pillar having a first end connected to the cathode.

### BRIEF DESCRIPTION OF DRAWINGS

The above and other aspects and features will be more apparent from the following description of embodiments with reference to the attached drawings, in which:
FIG. 1 is a block diagram representing a schematic configuration of an image sensor according to an example embodiment.
FIG. 2 is a circuit diagram representing an example of a schematic configuration of a pixel according to an example embodiment.
FIG. 3 is a drawing representing a lamination structure of a pixel array according to an example embodiment.
FIG. 4A is a cross-sectional view representing a structure of a unit element according to an example embodiment.
FIG. 4B is a plan view of a unit element according to an example embodiment.
FIG. 5A is a diagram for explaining a manufacturing method of a unit pixel according to an example embodiment.
FIG. 5B is a diagram for explaining a manufacturing method of a unit pixel according to an example embodiment.
FIG. 6A is a diagram for explaining a manufacturing method of a unit pixel according to an example embodiment.
FIG. 6B is a diagram for explaining a manufacturing method of a unit pixel according to an example embodiment.
FIG. 7A is a diagram for explaining a manufacturing method of a unit pixel according to an example embodiment.
FIG. 7B is a diagram for explaining a manufacturing method of a unit pixel according to an example embodiment.
FIG. 8A is a diagram for explaining a manufacturing method of a unit pixel according to an example embodiment.
FIG. 8B is a diagram for explaining a manufacturing method of a unit pixel according to an example embodiment.
FIG. 9A is a diagram for explaining a manufacturing method of a unit pixel according to an example embodiment.
FIG. 9B is a diagram for explaining a manufacturing method of a unit pixel according to an example embodiment.
FIG. 10A is a diagram for explaining a manufacturing method of a unit pixel according to an example embodiment.
FIG. 10B is a diagram for explaining a manufacturing method of a unit pixel according to an example embodiment.
FIG. 11A is a diagram for explaining a manufacturing method of a unit pixel according to an example embodiment.
FIG. 11B is a diagram for explaining a manufacturing method of a unit pixel according to an example embodiment.
FIG. 12A is a diagram for explaining a manufacturing method of a unit pixel according to an example embodiment.
FIG. 12B is a diagram for explaining a manufacturing method of a unit pixel according to an example embodiment.
FIG. 13A is a diagram for explaining a manufacturing method of a unit pixel according to an example embodiment.
FIG. 13B is a diagram for explaining a manufacturing method of a unit pixel according to an example embodiment.
FIG. 14A is a diagram for explaining a manufacturing method of a unit pixel according to an example embodiment.
FIG. 14B is a diagram for explaining a manufacturing method of a unit pixel according to an example embodiment.
FIG. 15A is a diagram for explaining a manufacturing method of a unit pixel according to an example embodiment.
FIG. 15B is a diagram for explaining a manufacturing method of a unit pixel according to an example embodiment.
FIG. 16A is a diagram for explaining a manufacturing method of a unit pixel according to an example embodiment.
FIG. 16B is a diagram for explaining a manufacturing method of a unit pixel according to an example embodiment.
FIG. 17 is a diagram for explaining a manufacturing method of a unit pixel according to an example embodiment.
FIG. 18A is a diagram for explaining a manufacturing method of a unit pixel according to an example embodiment.
FIG. 18B is a diagram for explaining a manufacturing method of a unit pixel according to an example embodiment.
FIG. 19A is a diagram for explaining a manufacturing method of a unit pixel according to an example embodiment.
FIG. 19B is a diagram for explaining a manufacturing method of a unit pixel according to an example embodiment.
FIG. 20 is a flowchart representing a manufacturing method of an image sensor according to an example embodiment.
FIG. 21 is a diagram representing an example of a layout interval of each layer when a clip transistor is reduced within a range satisfying layout rules for each layer configuring a clip transistor according to an example embodiment.
FIG. 22 is a drawing represent the configuration of a gate that is also used as a reflector according to an example embodiment.
FIG. 23A is a diagram for explaining resistance control between a cathode of a single-photon avalanche diode (SPAD) element and a P-type diffusion layer of a clip transistor according to an example embodiment.
FIG. 23B is a diagram for explaining resistance control between a cathode of a SPAD element and a P-type diffusion layer of a clip transistor according to an example embodiment.
FIG. 24 is a circuit diagram representing an example of a schematic configuration of a pixel according to an example embodiment.
FIG. 25A is a cross-sectional view representing a structure of a unit element according to an example embodiment.
FIG. 25B is a plan view of a unit element according to an example embodiment.
FIG. 26A is a diagram for explaining a manufacturing method of a unit pixel according to an example embodiment.
FIG. 26B is a diagram for explaining a manufacturing method of a unit pixel according to an example embodiment.
FIG. 27A is a diagram for explaining a manufacturing method of a unit pixel according to an example embodiment.
FIG. 27B is a diagram for explaining a manufacturing method of a unit pixel according to an example embodiment.
FIG. 28A is a diagram for explaining a manufacturing method of a unit pixel according to an example embodiment.
FIG. 28B is a diagram for explaining a manufacturing method of a unit pixel according to an example embodiment.
FIG. 29A is a diagram for explaining a manufacturing method of a unit pixel according to an example embodiment.
FIG. 29B is a diagram for explaining a manufacturing method of a unit pixel according to an example embodiment.
FIG. 30A is a diagram for explaining a manufacturing method of a unit pixel according to an example embodiment.
FIG. 30B is a diagram for explaining a manufacturing method of a unit pixel according to an example embodiment.
FIG. 31A is a diagram for explaining a manufacturing method of a unit pixel according to an example embodiment.
FIG. 31B is a diagram for explaining a manufacturing method of a unit pixel according to an example embodiment.
FIG. 32A is a diagram for explaining a manufacturing method of a unit pixel according to an example embodiment.
FIG. 32B is a diagram for explaining a manufacturing method of a unit pixel according to an example embodiment.
FIG. 33A is a diagram for explaining a manufacturing method of a unit pixel according to an example embodiment.
FIG. 33B is a diagram for explaining a manufacturing method of a unit pixel according to an example embodiment.
FIG. 34A is a diagram for explaining a manufacturing method of a unit pixel according to an example embodiment.
FIG. 34B is a diagram for explaining a manufacturing method of a unit pixel according to an example embodiment.
FIG. 35A is a diagram for explaining a manufacturing method of a unit pixel according to an example embodiment.
FIG. 35B is a diagram for explaining a manufacturing method of a unit pixel according to an example embodiment.
FIG. 36A is a diagram for explaining a manufacturing method of a unit pixel according to an example embodiment.
FIG. 36B is a diagram for explaining a manufacturing method of a unit pixel according to an example embodiment.
FIG. 37A is a diagram for explaining a manufacturing method of a unit pixel according to an example embodiment.
FIG. 37B is a diagram for explaining a manufacturing method of a unit pixel according to an example embodiment.
FIG. 38A is a diagram for explaining a manufacturing method of a unit pixel according to an example embodiment.
FIG. 38B is a diagram for explaining a manufacturing method of a unit pixel according to an example embodiment.
FIG. 39A is a diagram for explaining a manufacturing method of a unit pixel according to an example embodiment.
FIG. 39B is a diagram for explaining a manufacturing method of a unit pixel according to an example embodiment.
FIG. 40 is a flowchart representing a manufacturing method of an image sensor according to an example embodiment.

### DETAILED DESCRIPTION

Hereinafter, embodiments are described in detail with reference to the accompanying drawings. Embodiments described herein are example embodiments, and thus, the present disclosure is not limited thereto, and may be realized in various other forms. Each embodiment provided in the following description is not excluded from being associated with one or more features of another example or another embodiment also provided herein or not provided herein but consistent with the present disclosure. Hereinafter, for the sake of clarity and convenience of explanation, the same reference numerals in the drawings refer to the same components, and the size of each component in the drawings is expressed at a different ratio than in reality.

Hereinafter, the expressions "upper" or "above" include not only things that are directly above/below/left/right in contact, but also things that are above/below/left/right in non-contact. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, there are no intervening elements or layers present.

Terms such as first and second are used to describe various components, but are only used to distinguish one component from another. These terms do not limit the material or structure of the components to others.

A component expressed in the singular includes plural components unless the context clearly indicates otherwise. Additionally, when it is said that a part "includes" a component, this does not exclude other components, unless otherwise specifically stated, but rather may additionally include other components.

In addition, terms such as "portion" and "module" described in the specification mean a unit that processes one or more functions or operations, and this is embodied by hardware or software, or by a combination of hardware and software.

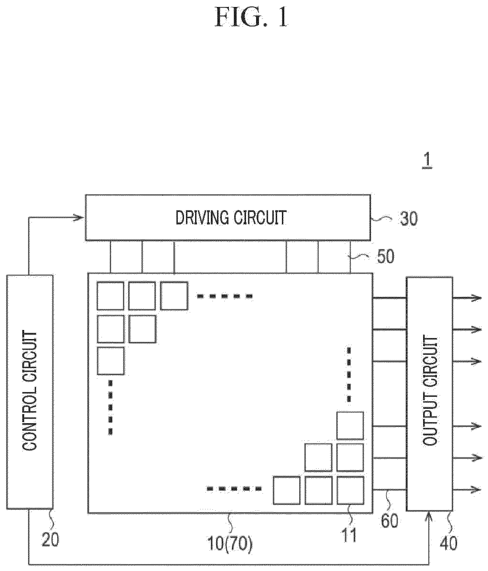

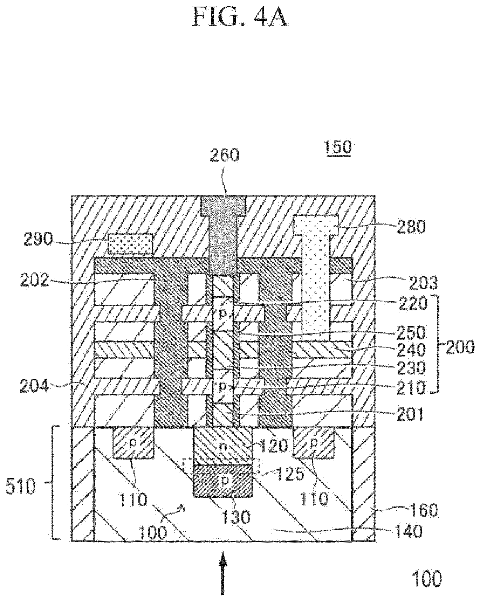

FIG. 1 is a block diagram representing a schematic configuration of the image sensor 1 according to an example embodiment. The image sensor 1 may be, for example, a back-illuminated image sensor 1. The image sensor 1 may also be a surface-illuminated image sensor 1. In the backside-illuminated image sensor 1, the side opposite to the element-forming surface on the substrate 510 may be the light incident surface (see FIG. 4A). In the frontside-illuminated image sensor 1, the element-forming surface may be the light incident surface. Hereinafter, for the sake of simplicity of the description, the image sensor 1 will be described as a back-illuminated image sensor, but example embodiments are not limited thereto. Hereinafter, the element forming surface in the substrate 510 is also referred to as "surface". A surface opposite to the element forming surface in the substrate 510 is also referred to as "back surface".

The image sensor 1 includes a pixel array 10, a control circuit 20, a driving circuit 30, and an output circuit 40.

The pixel array 10 includes a plurality of pixels 11 arranged in a matrix format. For each pixel 11, a pixel driving line 50 may be connected for each column, and an output signal line 60 may be connected for each row. The pixel driving line 50 may be connected to output terminals of the driving circuit 30, corresponding to respective columns. The output signal line 60 may be connected to input terminals of the output circuit 40, corresponding to respective rows.

The driving circuit 30 includes a shift register, an address decoder, or the like, and may drive all pixels 11 of the pixel array 10 simultaneously or by column. The driving circuit 30 includes a circuit that applies a quench voltage VQ, described later, to each pixel 11. When driving respective pixels 11 by column, the driving circuit 30 may apply a selection signal voltage VSEL to each pixel 11 of the selected column. In this case, by the selection signal voltage VSEL, a respective pixel 11 may be selected, a power source voltage may be applied only to the selected pixel 11, and a detection signal VOUT may be output from the corresponding pixel 11.

The detection signal VOUT output from each pixel 11 may be input to the output circuit 40 through each output signal line 60. The output circuit 40 may output the detection signal VOUT input from each pixel 11 as an image signal.

The control circuit 20 includes a timing generator, or the like, configured generate various timing signals, and may control the driving circuit 30 and the output circuit 40 based on various timing signals generated by the timing generator.

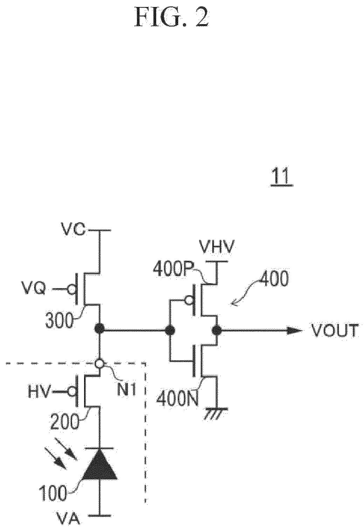

FIG. 2 is a circuit diagram representing an example of a schematic configuration of the pixel 11 according to an example embodiment.

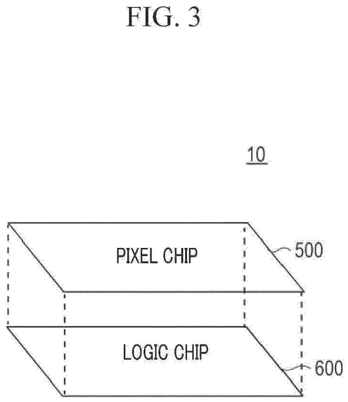

The pixel 11 includes a single-photon avalanche diode (SPAD) element 100, a clip transistor 200, a quench resistor 300, and an inverter 400. The quench resistor 300 may be implemented by, or include, a recharge transistor. The SPAD element 100 is an example of an avalanche photodiode. Hereinafter, for the sake of simplicity of description, the case that the avalanche photodiode is the SPAD element 100 will be described as an example, but example embodiments are not limited thereto. As will be described later, the SPAD element 100 and the clip transistor 200 may be formed in a pixel chip 500 (see FIG. 3), and the quench resistor 300 and the inverter 400 may be formed in a logic chip 600. Each pixel 11 may be formed by having the pixel chip 500 and the logic chip 600 adjusted in position for each pixel 11 and bonded by a hybrid bump 260 (see FIG. 4A). In FIG. 2, a connection point where the clip transistor 200 and the quench resistor 300 may be connected by the junction of the pixel chip 500 and the logic chip 600 is indicated as a node N1. In addition, a boundary of the pixel chip 500 and the logic chip 600 may be indicated by a broken line.

The SPAD element 100 may be a light-receiving element, and when a photon is incident while a reverse bias higher than a breakdown voltage is applied between an anode and a cathode, an avalanche current may be generated. An anode voltage VA may be applied to the anode of the SPAD element 100, and a cathode voltage VC may be applied to the cathode through the quench resistor 300 and the clip transistor 200. The anode voltage VA may be set to, for example, -15V to -30V. The cathode voltage VC may be set to, for example, 3V. The SPAD element 100 may operate in Geiger mode by applying a reverse bias voltage higher than a breakdown voltage, and may be capable of detecting one photon.

The clip transistor 200 may be supplied with a clip voltage HV to the gate and clips so that a source voltage of the clip transistor 200 does not fall below a predetermined value. That is, the clip transistor 200 may clip a voltage of the node N1, which may be a connection point of the logic chip 600 and the pixel chip 500. The clip transistor 200 may be formed by, for example, a p-type metal-oxide semiconductor (PMOS).

The quench resistor 300 may operate as a quench resistor when the quenching voltage VQ supplied from the driving circuit 30 is applied to a gate of a transistor forming the quench resistor 300. Additionally, the quench resistor 300 has the function of performing a recharge operation, returning the voltage supplied to the SPAD element 100 back to VC by allowing the current corresponding to the voltage drop during the quenching operation to flow. The quench resistor 300 may be formed by, for example, a PMOS transistor.

The current flowing through the SPAD element 100 may be converted to a voltage by the quench resistor 300, and output to the inverter 400.

The inverter 400 may be formed by connecting a PMOS transistor 400P and an n-type metal-oxide semiconductor (NMOS) transistor 400N in series. The source of the PMOS transistor 400P may be connected to a power source voltage VHV for driving the digital circuit, and the drain of the PMOS transistor 400P may be connected to the drain of the NMOS transistor 400N. The drain of the NMOS transistor 400N may be connected to the drain of the PMOS transistor 400P, and the source of the NMOS transistor 400N may be grounded. The gates of the PMOS transistor 400P and the NMOS transistor 400N may be connected to each other, and this connection point may serve as the input of the inverter 400. The connection point between the drain of the PMOS transistor 400P and the drain of the NMOS transistor 400N may serve as the output of the inverter 400. The input of the inverter 400 may be connected to the node N1, which may be a connection point of the SPAD element 100 and the quench resistor 300.

The inverter 400 may convert the input voltage to a digital signal and output the digital signal as the detection signal VOUT. Additionally, a buffer for impedance conversion may be provided at the output of the inverter 400, allowing the impedance-converted detection signal VOUT to be output from each pixel 11.

The detection signal VOUT may be input to the output circuit 40. The output circuit 40 may output the detection signal VOUT to a processor, for example, through time-to-digital converter (TDC). The processor may perform various processing of the detection signal VOUT.

The quench resistor 300, the inverter 400, the control circuit 20, the driving circuit 30, and the output circuit 40 may configure a logic circuit that processes a signal received from the pixel chip 500. A circuit for processing the detection signal VOUT output from the inverter 400 may be further included in the logic circuit. A threshold voltage of the transistor of the logic circuit may be lower than a threshold voltage of the clip transistor 200. Accordingly, power consumption of the image sensor 1 may be reduced.

When a photon is incident on the SPAD element 100 while a reverse bias voltage VSPAD higher than a breakdown voltage is applied to the SPAD element 100 through the quench resistor 300 and the clip transistor 200, an avalanche current may be generated in the SPAD element 100. The reverse bias voltage VSPAD may be a sum of the absolute value of the anode voltage VA and the absolute value of the cathode voltage VC. As the avalanche current flows through the quench resistor 300, the voltage of node N1 may drop. When the voltage of node N1 falls below the threshold voltage of the PMOS transistor 400P in the inverter 400, the PMOS transistor 400P may conduct, causing the inverter 400 to output the power source voltage VHV as a high-level detection signal.

If the voltage of node N1 continues to drop and the gate-source voltage of the clip transistor 200 falls below the threshold voltage, the current flow through the clip transistor 200 may stop, so that the voltage of the node N1 may be clipped. In addition, the voltage being applied to the SPAD element 100 may become lower than the breakdown voltage. Accordingly, the avalanche current does not flow, and the voltage of the node N1 increases. When the voltage of node N1 exceeds the threshold voltage of the NMOS transistor 400N of the inverter 400, the NMOS transistor 400N may conduct, causing the inverter 400 to output the ground voltage as a low-level detection signal.

FIG. 3 is a drawing representing a lamination structure of the pixel array 10 according to an example embodiment.

The pixels 11 may be arranged in an array format to form the pixel array 10. The SPAD elements 100 may form an element array 70 by being arranged in an array. The pixel array 10 has a structure in which the pixel chip 500 and the logic chip 600 is stacked. The pixel chip 500 may be a semiconductor chip in which the SPAD element 100 and the clip transistor 200 are formed in an array format. The logic chip 600 may be a semiconductor chip in which the quench resistor 300 and the inverter 400 are formed at positions corresponding to each SPAD element 100. In the logic chip 600, the control circuit 20, the driving circuit 30, and the output circuit 40 may also be formed. The above-described buffer for impedance converting the detection signal VOUT may be formed in the logic chip 600.

Hereinafter, a unit of a device group including the SPAD element 100 and the clip transistor 200, formed in the pixel chip 500, may also referred to as a "unit element 150".

The pixel chip 500 and the logic chip 600 may be bonded by, for example, flattening each of their bonding surfaces and bringing them into contact. Specifically, the pixel chip 500 and the logic chip 600 may be bonded by metal bonding the hybrid bump 260 exposed on a bonding surface of the pixel chip 500 and a metal pad exposed on a bonding surface of the logic chip 600.

FIG. 4A is a cross-sectional view representing a structure of the unit element 150 according to an example embodiment.

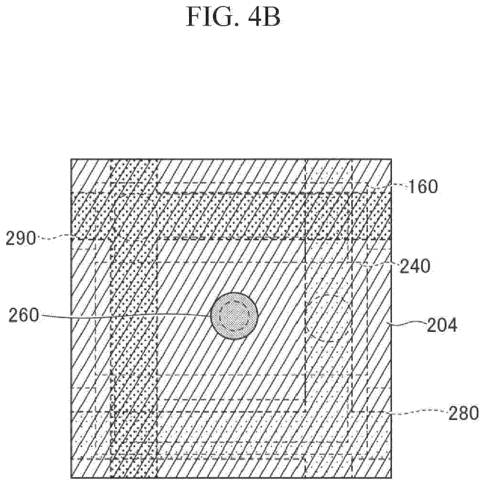

FIG. 4B is a plan view of the unit element 150 according to an example embodiment. In FIG. 4A, incident light incident on the light incident surface of the unit element 150 is indicated by an arrow.

The unit element 150 may be formed in a plural quantity on the substrate 510 of the pixel chip 500. The substrate 510 is, for example, a monocrystalline silicon substrate.

The unit element 150 includes a pixel isolation layer 160. The pixel isolation layer 160 may separate the SPAD element 100 from other SPAD elements 100. The pixel isolation layers 160 of a plurality of SPAD elements 100 formed on the substrate 510 may be interconnected, forming a lattice shape when viewed in plan from the light incident surface.

A photoelectric conversion region 140 of the SPAD element 100 may be a region where photoelectric conversion of incident light occurs, and pairs of electrons and holes are generated. The photoelectric conversion region 140 may have a potential so that electrons generated by the photoelectric conversion may be gathered in an avalanche region 125.

An anode electrode layer 110 may function as the anode of the SPAD element 100. The anode electrode layer 110 may have a first conductivity type. The first conductivity type may be, for example, P-type.

A cathode electrode layer 120 may function as a cathode of the SPAD element 100. The cathode electrode layer 120 may have a second conductivity type. The second conductivity type may be, for example, N-type.

Hereinafter, for the sake of simplicity of the description, the case where the first conductivity type may be P-type, and the second conductivity type may be N-type will be described as an example, but example embodiments are not limited thereto.

A P-type semiconductor layer 130 may be in contact with the cathode electrode layer 120. For example, the P-type semiconductor layer 130 may be bonded to an N-typed cathode electrode layer 120, and a **PN** junction of the SPAD element 100 may be formed. The **PN** junction may form the avalanche region 125, and function as an amplification region which accelerates the charges introduced into the P-type semiconductor layer 130 to generate the avalanche current.

The anode electrode layer 110 of the SPAD element 100 may be symmetrical to the cathode electrode layer 120, on a surface of the substrate 510 of the pixel chip 500.

An anti-reflection layer for preventing or reducing reflection of incident light may be formed on the light incident surface of the substrate 510.

A color filter and on-chip lens corresponding to respective SPAD element 100 may be formed on the anti-reflection layer. The color filter may be formed as one of a color filter selectively transmitting light of red (R) wavelength component, a color filter selectively transmitting light of green (G) wavelength component, or a color filter selectively transmitting light of blue (B) wavelength component, corresponding to each SPAD element 100. The color filters may be formed in a Bayer arrangement.

The clip transistor 200 may be formed on the surface of the substrate 510. The clip transistor 200 may be a gate-all-around type MOS transistor. Specifically, the clip transistor 200 may be a gate-all-around type PMOS transistor including a pillar-shaped channel 230 formed by a portion of a pillar-shaped active pillar 201 having a first end connected to the cathode electrode layer 120 of the SPAD element 100, and a planar gate 240 surrounding the channel 230. The hybrid bump 260 may be connected to a second end of the pillar-shaped channel 230 of the clip transistor 200. The hybrid bump 260 may form an electrode pad.

The gate 240 may be at least one of polysilicon or metal.

The first end of the pillar-shaped active pillar 201 may be connected to the cathode electrode layer 120, and may vertically overlap a center of the cathode electrode layer 120 on the surface of the substrate 510.

The active pillar 201 may be formed by, for example, polysilicon or monocrystalline silicon. In the active pillar 201, a source 220 and a drain 210 may be formed on both sides of the channel 230. In addition, a gate oxide layer 250 may be formed on a surface of a region of the active pillar 201 where the channel 230 is formed. Accordingly, the clip transistor 200 may be formed.

On the clip transistor 200, a gate wire 280, an anode wiring 290, and the hybrid bump 260 may be formed. The gate wire 280 may be connected to the gate 240 through a via. The anode wiring 290 may be connected to the anode electrode layer 110 through a via. The anode wiring 290 may be a wire for supplying the anode voltage VA to the SPAD element 100. The gate wire 280 may be a wire for supplying the clip voltage HV to the clip transistor 200. The hybrid bump 260 may be exposed on the surface of the unit element 150.

The hybrid bump 260 may be bonded to a connection pad exposed on the surface of the logic chip 600 by metal bonding. Accordingly, the pixel chip 500 and the logic chip 600 may be bonded.

Each layer of the clip transistor 200, and each layer of the gate wire 280, the anode wiring 290, and the hybrid bump 260 may be insulated from each other by an interlayer insulation layer 203 and an insulation layer 204.

A column 202 of an insulation material may be provided around the pillar-shaped active pillar 201.

The logic chip 600 may be configured with the substrate and a wiring layer. In this case, elements of a logic circuit, including transistors included in the quench resistor 300 and the inverter 400 on the substrate, may be each formed at positions corresponding to the unit element 150. In addition, wiring for forming the logic circuit including the wiring connecting the quench resistor 300 and the inverter 400, or wiring including connection pad, may be formed on the wiring layer.

A manufacturing method of the unit element 150 according to an example embodiment will be described.

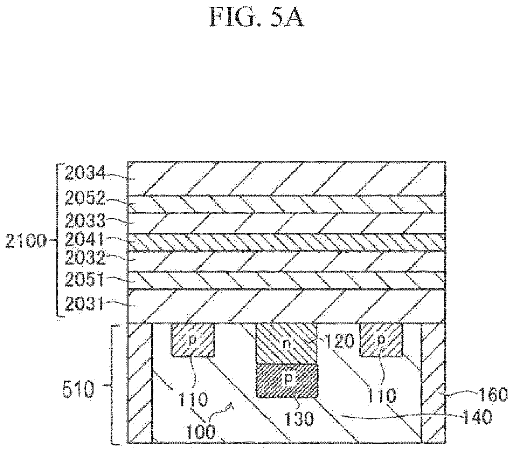

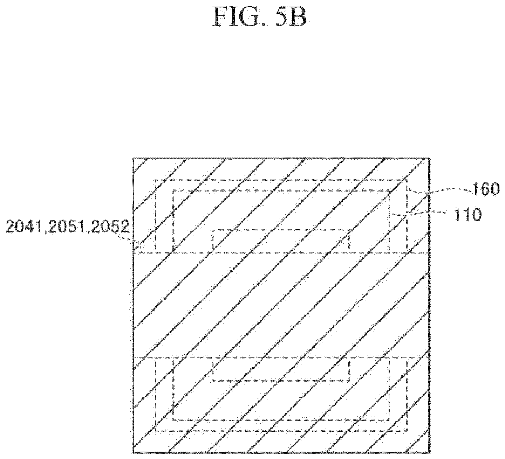

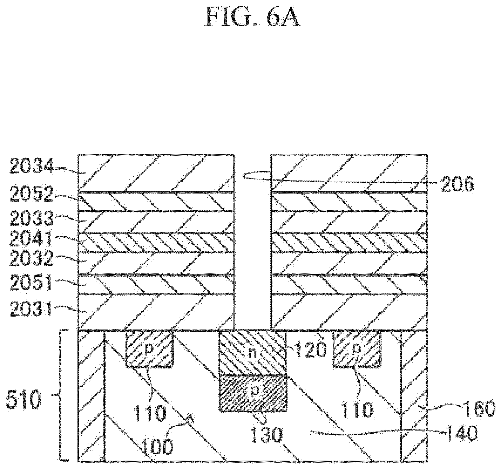

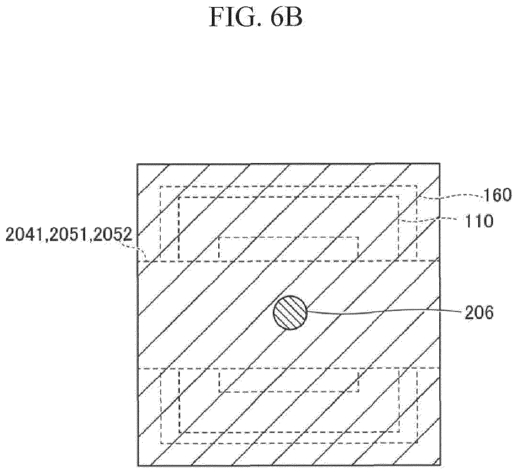

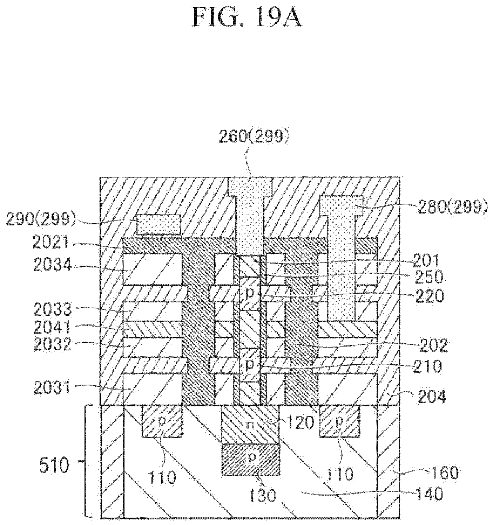

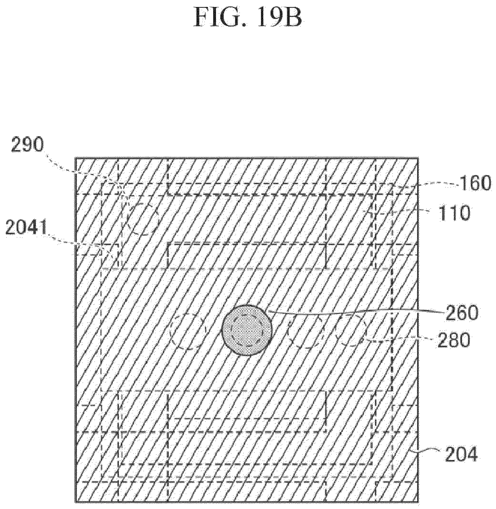

FIG. 5A to FIG. 19B are diagrams for explaining a manufacturing method of the unit element 150 according to an example embodiment. The drawings corresponding to "A" following each drawing number (i.e., FIG. 5A, FIG. 6A, ..., FIG. 19A) are drawings for explaining a manufacturing method of the unit element 150 by a cross-sectional view, and similarly, the drawings corresponding to "B" following each drawing number (i.e., FIG. 5B, FIG. 6B, ..., FIG. 19B) are plan view drawings corresponding to the cross-sectional views.

As shown in FIG. 5A and FIG. 5B, on the substrate 510 of the pixel chip 500 where the SPAD element 100 is formed, a laminated film 2100 having a first sacrificial layer 2051, a gate layer 2041, and a second sacrificial layer 2052 may be formed. More specifically, the laminated film 2100 may be formed by sequentially forming the first sacrificial layer 2051, a first interlayer insulation layer 2032, the gate layer 2041, a second interlayer insulation layer 2033, and the second sacrificial layer 2052, on the substrate 510. The laminated film 2100 may be formed, in which a lowermost interlayer insulation layer 2031 is formed below the first sacrificial layer 2051, and an uppermost interlayer insulation layer 2034 is formed on the second sacrificial layer 2052. The first sacrificial layer 2051 and the second sacrificial layer 2052 may include silicon nitride (SiN). The first interlayer insulation layer 2032 and the second interlayer insulation layer 2033 may include silicon dioxide (SiO2). The gate layer 2041 may include at least one of polysilicon or metal. The first sacrificial layer 2051, the first interlayer insulation layer 2032, the gate layer 2041, the second interlayer insulation layer 2033, and the second sacrificial layer 2052 may be formed, then patterned by anisotropic etching using a resist, and thereafter filled again by silicon dioxide (SiO2), thereby planarizing the surface. The lowermost interlayer insulation layer 2031 and the uppermost interlayer insulation layer 2034 may include silicon dioxide (SiO2).

As shown in FIG. 6A and FIG. 6B, a first hole 206 penetrating the laminated film 2100 may be formed, and the cathode electrode layer 120 may be exposed through the first hole 206. The first hole 206 may be formed by, for example, anisotropic etching.

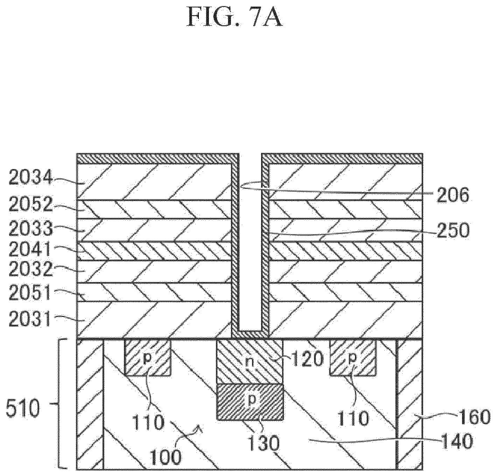

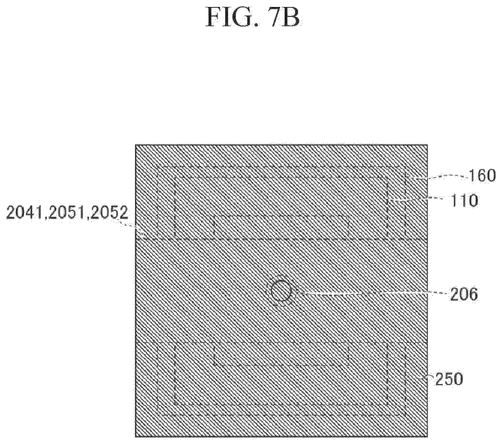

As shown in FIG. 7A and FIG. 7B, the gate oxide layer 250 may be formed on a side wall of the formed first hole 206. The gate oxide layer 250 may include silicon dioxide (SiO2).

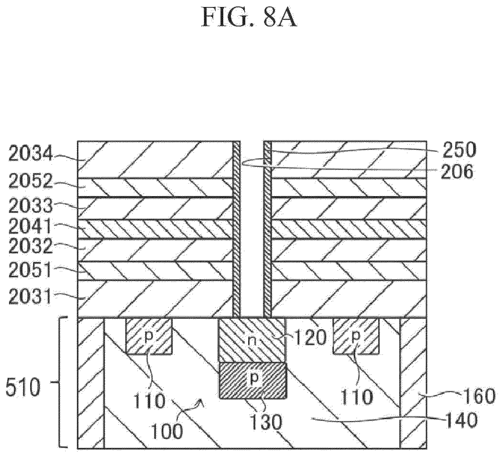

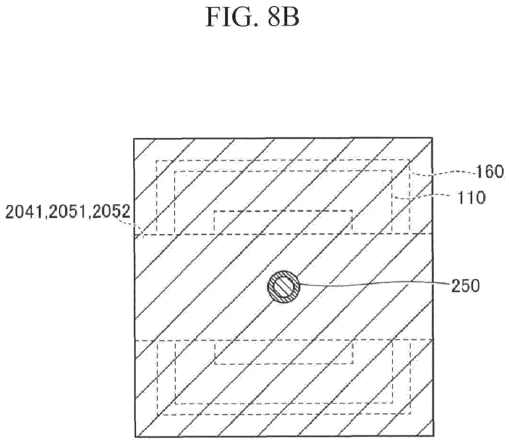

As shown in FIG. 8A and FIG. 8B, a portion of the gate oxide layer 250 in contact with the cathode electrode layer 120 at a bottom of the first hole 206, and a portion on the uppermost interlayer insulation layer 2034 may be removed by anisotropic etching. Accordingly, the cathode electrode layer 120 may be exposed.

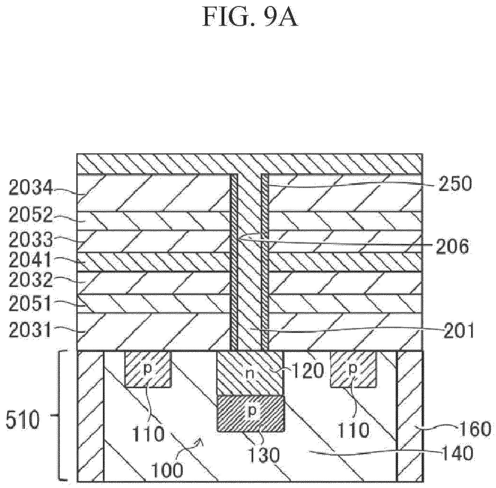

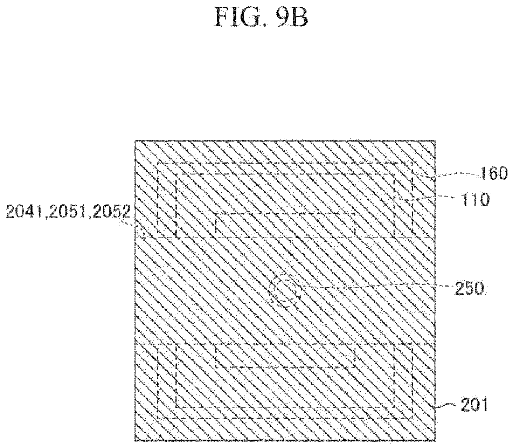

As shown in FIG. 9A and FIG. 9B, the pillar-shaped active pillar 201 may be formed within the first hole 206, to be connected to the cathode electrode layer 120 of the SPAD element 100. The active pillar 201 may include, for example, polysilicon.

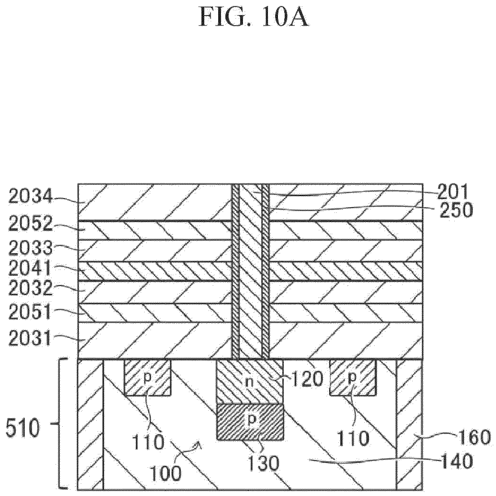

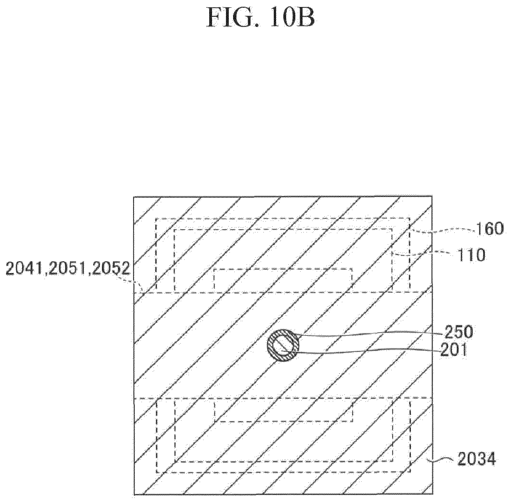

As shown in FIG. 10A and FIG. 10B, a portion of the active pillar 201 on the uppermost interlayer insulation layer 2034 may be removed. The portion of the active pillar 201 on the uppermost interlayer insulation layer 2034 may be removed by, for example, chemical mechanical polishing (CMP).

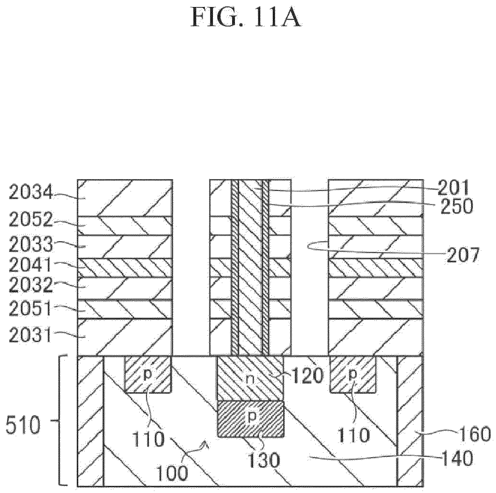

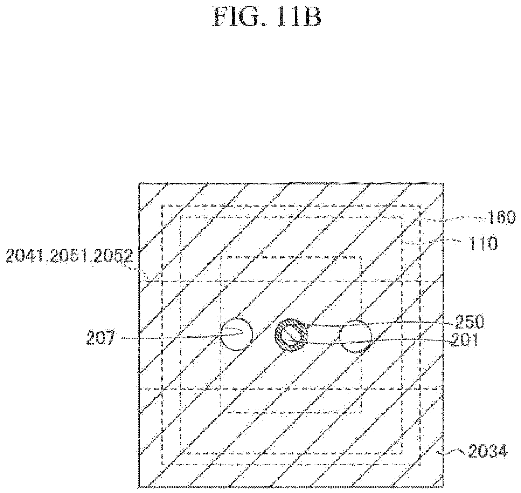

As shown in FIG. 11A and FIG. 11B, a second hole 207 penetrating the laminated film 2100 may be formed around the active pillar 201. For example, two second holes 207 may be formed, and the active pillar 201 may be provided between the two second holes 207. The second holes 207 may be formed by, for example, anisotropic etching.

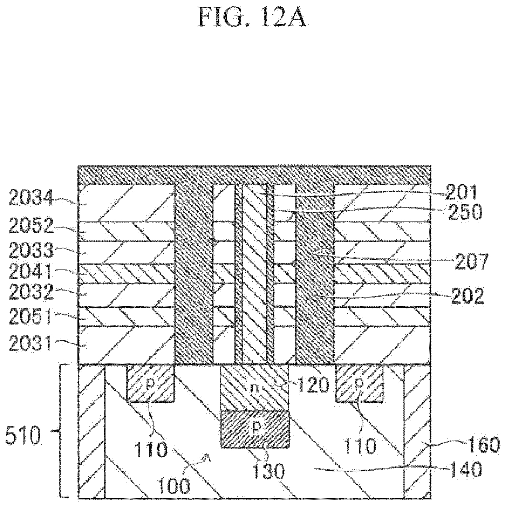

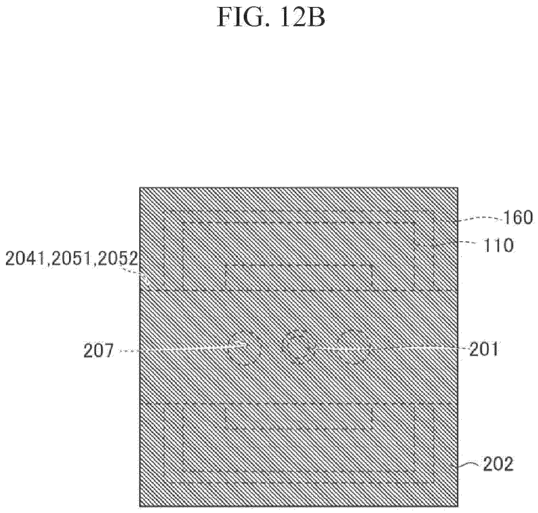

As shown in FIG. 12A and FIG. 12B, the column 202 of the insulation material may be formed by forming an insulation material in the second hole 207. For example, the insulation material may be formed by charging the insulation material into the second hole 207. The column 202 of the insulation material may include silicon dioxide (SiO2). The column 202 may increase structural stability of the laminated film 2100. Thus, by forming the column 202 of the insulation material, the laminated film 2100 may be prevented from being collapsed during the process of removing the first sacrificial layer 2051 and the second sacrificial layer 2052, to be described later.

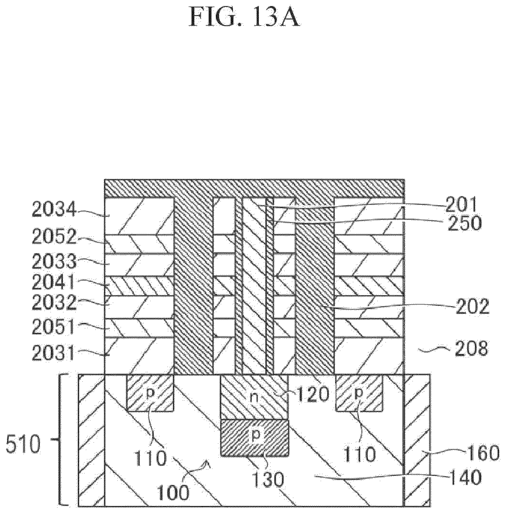

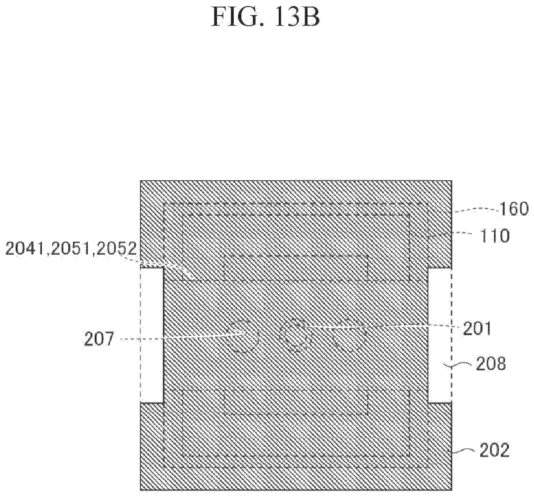

As shown in FIG. 13A and FIG. 13B, for example, a trench 208 penetrating the laminated film 2100 may be formed for each SPAD element 100, such that a portion of the trench 208 overlaps with the pixel isolation layer 160 that separates the SPAD elements 100 from each other. The trench 208 may be formed by, for example, anisotropic etching.

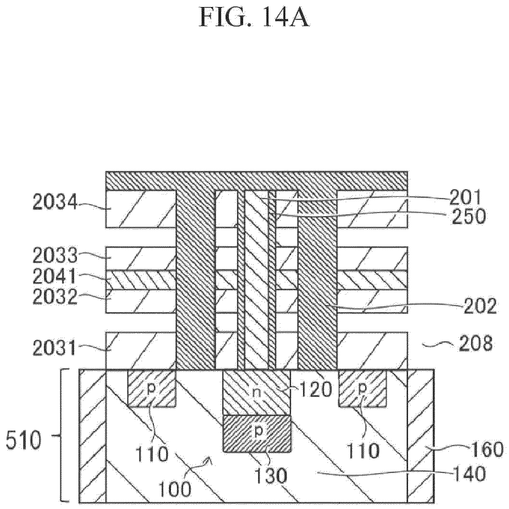

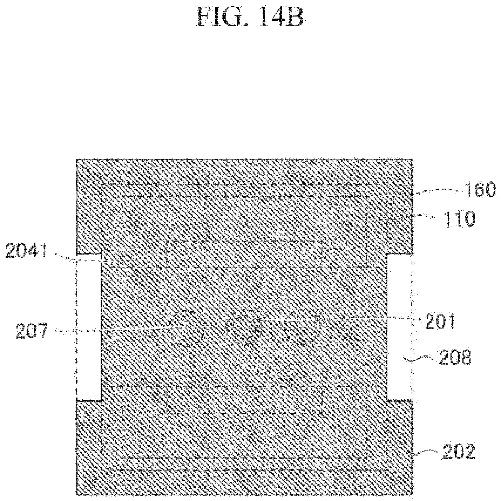

As shown in FIG. 14A and FIG. 14B, the first sacrificial layer 2051 and the second sacrificial layer 2052 may be removed to expose the gate oxide layer 250 may be exposed. The first sacrificial layer 2051 and the second sacrificial layer 2052 may be removed by wet etching with adjusted selectivity.

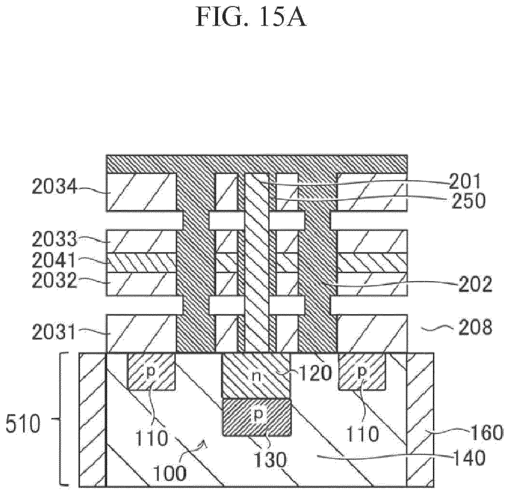

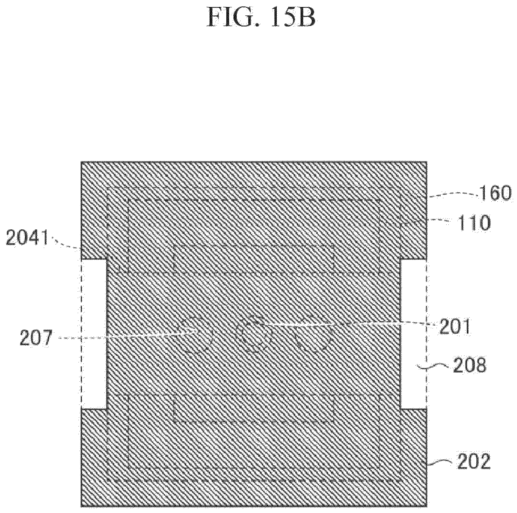

As shown in FIG. 15A and FIG. 15B, a portion of the exposed gate oxide layer 250 may be removed to expose a portion of the active pillar 201. The portion of the gate oxide layer 250 may be removed by wet etching with adjusted selectivity.

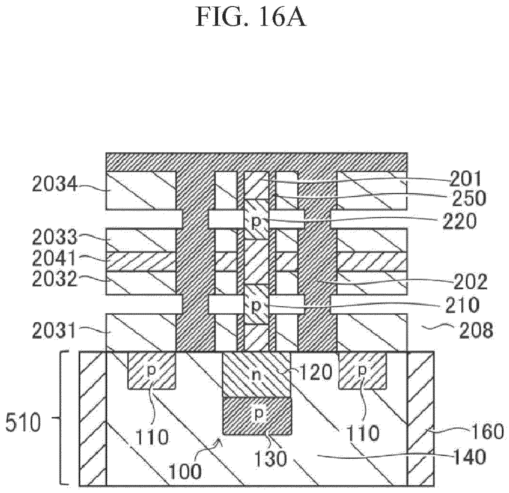

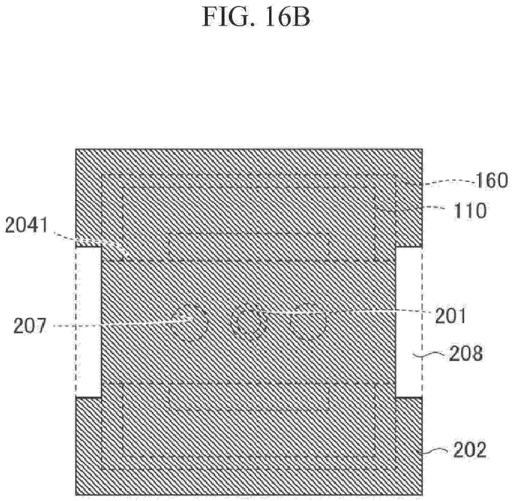

As shown in FIG. 16A and FIG. 16B, a diffusion layer may be formed on a portion of the exposed active pillar 201, the source 220 and the drain 210 of the clip transistor 200. The diffusion layer may be formed by plasma doping or solid-state diffusion.

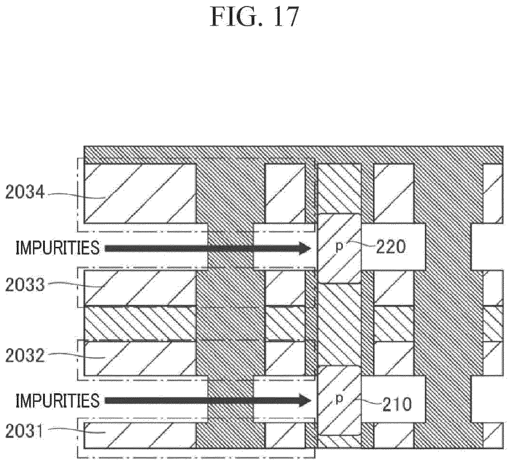

FIG. 17 is a cross-sectional of a portion of the unit element 150 according to an example embodiment. As shown in FIG. 17, an acceptor of a P-type impurity may be doped into the active pillar 201 by using the lowermost interlayer insulation layer 2031, the first interlayer insulation layer 2032, the second interlayer insulation layer 2033, and the uppermost interlayer insulation layer 2034 as a mask, the source 220 and the drain 210 may be formed by self-alignment. For example, impurities may be implanted lateral direction only in the regions mainly defined by the 2051 and 2052 film thicknesses, which reduces a variation in source-drain position and source-drain distance, thereby reducing the variation in transistor characteristics. Accordingly, non-uniformity of characteristics of the clip transistor 200 may be reduced.

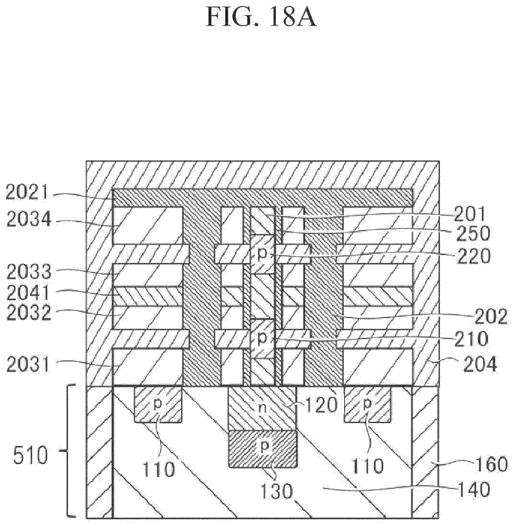

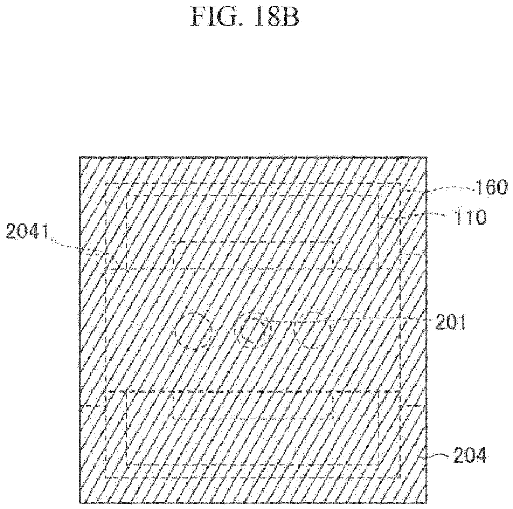

As shown in FIG. 18A and FIG. 18B, the trench 208 and spaces between the lowermost interlayer insulation layer 2031, the first interlayer insulation layer 2032, the second interlayer insulation layer 2033, and the uppermost interlayer insulation layer 2034 may be filled with the insulation layer 204. The insulation layer 204 may include silicon dioxide (SiO2).

As shown in FIG. 19A and FIG. 19B, a wiring layer 299 including the gate wire 280 electrically connected to the gate layer 2041, the anode wiring 290, and the hybrid bump 260, may be formed.

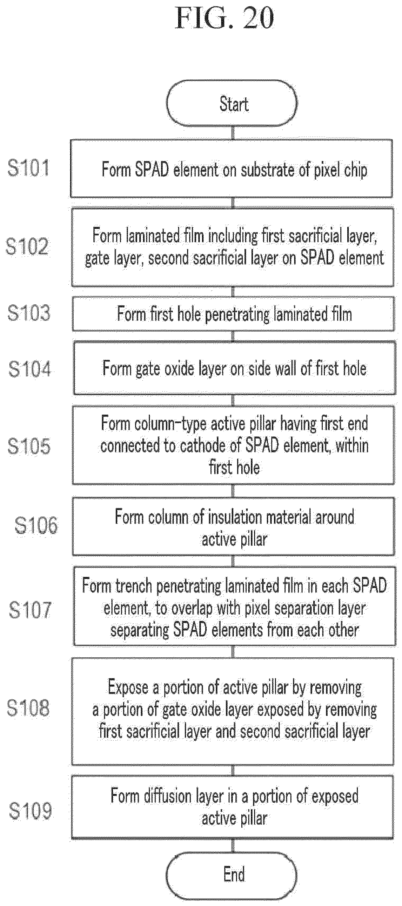

FIG. 20 is a flowchart representing a manufacturing method of the image sensor 1 according to an example embodiment.

At operation S101, the SPAD element 100 may be formed on the substrate 510 of the pixel chip 500.

At operation S102, on the SPAD element 100, the laminated film 2100 including the first sacrificial layer 2051, the gate layer 2041, and the second sacrificial layer 2052 may be formed.

At operation S103, the first hole 206 penetrating the laminated film 2100 may be formed.

At operation S104, the gate oxide layer 250 may be formed on the side wall of the formed first hole 206.

At operation S105, within the first hole 206, the pillar-shaped active pillar 201 having a first end connected to the cathode electrode layer 120 of the SPAD element 100 may be formed.

At operation S106, the column 202 of the insulation material may be formed around the active pillar 201.

At operation S107, a trench 208 penetrating the laminated film 2100 may be formed between each SPAD element 100 such that the trench 208 overlaps with the pixel isolation layer 160 that separates the SPAD elements 100 from each other.

At operation S108, by removing a portion of the gate oxide layer 250 exposed by removing the first sacrificial layer 2051 and the second sacrificial layer 2052, a portion of the active pillar 201 may be exposed.

At operation S109, by forming the diffusion layer on a portion of the exposed active pillar 201, the source 220 and the drain 210 of the clip transistor 200 may be formed.

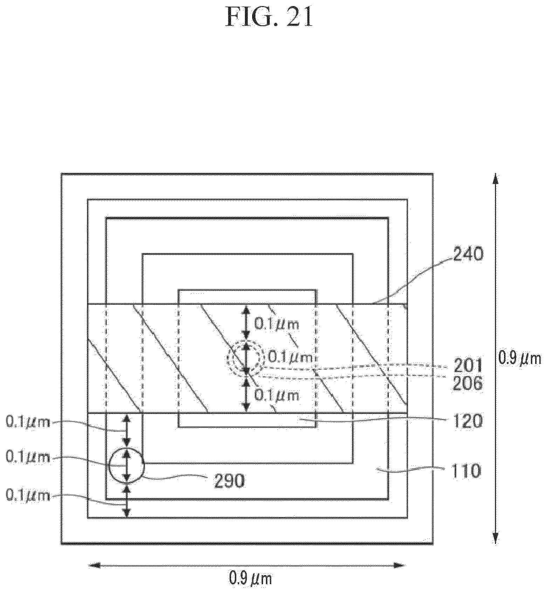

FIG. 21 is a diagram representing an example of a layout interval of each layer when the clip transistor may be reduced 200 within a range satisfying layout rules specified to ensure reliability for each layer configuring the clip transistor 200 according to an example embodiment..

The layout rules may include a minimum diameter of the first hole 206 in which the active pillar 201 may be formed, a minimum distance between the first hole 206 and an end of the gate 240 overlapping with the first hole 206, or the like.

In the example of FIG. 21, it may be shown that, when the layout may be performed under the constraint that the distance between the gate 240 and the first hole 206 and the distance between the gate 240 and the anode wiring 290 may be spaced by at least 0.1 µm, the pixel 11 may be miniaturized to 0.9 µm × 0.9 µm.

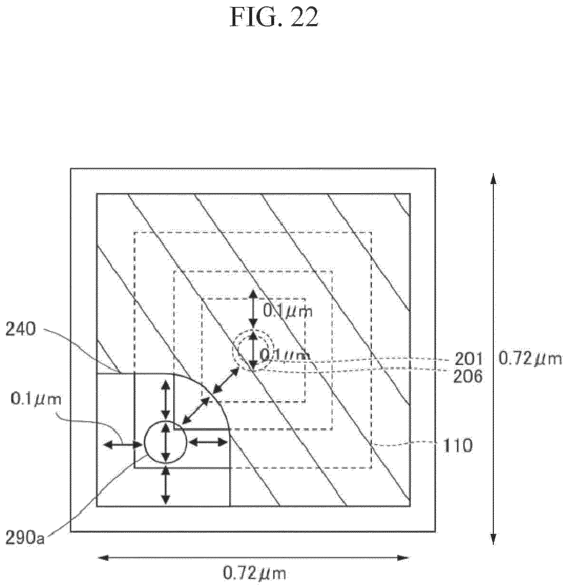

FIG. 22 is a drawing represent the configuration of the gate 240 that may be also used as a reflector according to an example embodiment. In the pixel 11, light that has reached the gate 240 without causing photoelectric conversion may be reflected back into the pixel 11, thereby reducing optical crosstalk to adjacent pixels.

By increasing an area of the gate 240 in a plan view, the gate 240 may also be used as a reflector. When the gate 240 is also used as a reflector the gate 240 may be formed with metal or polysilicon.

In the example of FIG. 22, the area of the gate 240 may be maximized while maintaining intervals between anode connection holes 290a for connecting the anode electrode layer 110 and the anode wiring 290. In addition, in the example of FIG. 22, by changing the shape of the gate 240, and reducing the area of the anode electrode layer 110, the pixel 11 may be miniaturized to a size of 0.72 µm × 0.72 µm.

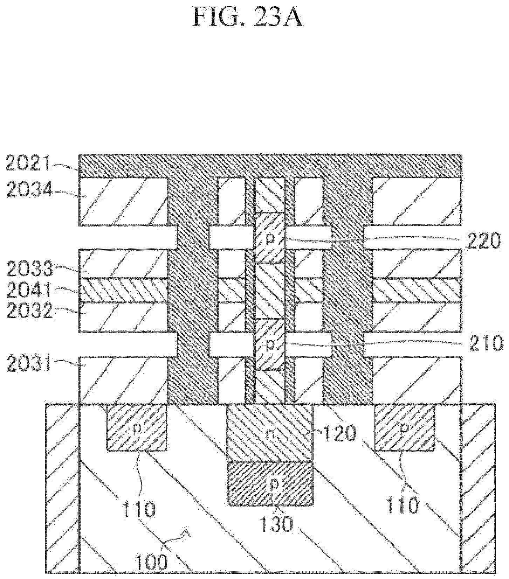

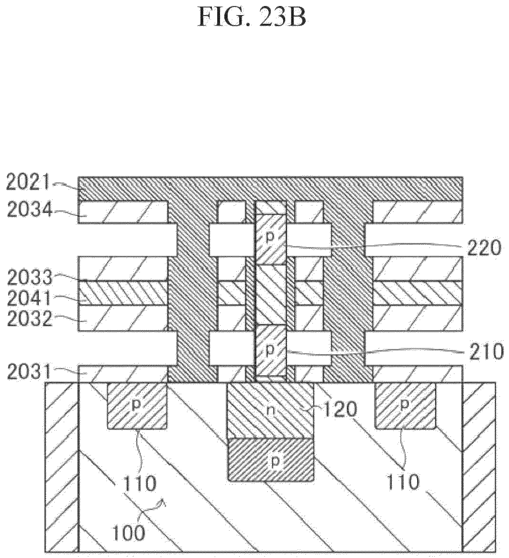

FIG. 23A and FIG. 23B are drawings for explaining resistance control between the cathode of the SPAD element 100 and the P-type diffusion layer of the clip transistor 200 according to an example embodiment. As shown in FIG. 23A and FIG. 23B, the resistance between the cathode of the SPAD element 100 and the P-type diffusion layer of the clip transistor 200 may be adjusted by adjusting a film thickness of the lowermost interlayer insulation layer 2031.

As shown in FIG. 23A and FIG. 23B, by controlling the film thickness of the lowermost interlayer insulation layer 2031, a distance between the cathode electrode layer 120 of the SPAD element 100 and the drain 210 of the clip transistor 200 may be controlled. Accordingly, by controlling a length of the active pillar 201 between the cathode electrode layer 120 and the drain 210, the resistance between the cathode electrode layer 120 and the drain 210 may be easily controlled.

A pixel according to another example embodiment will be described. Differences between features described above will be described.

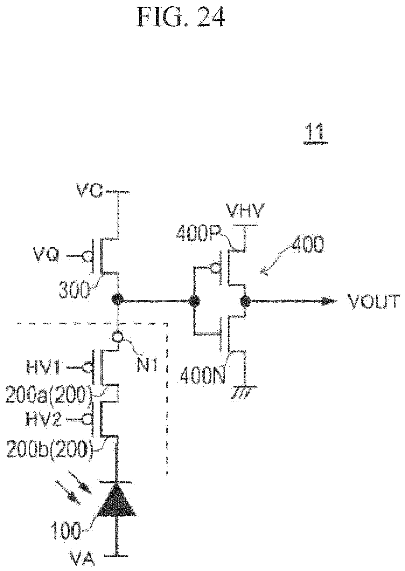

FIG. 24 may be a circuit diagram representing an example of a schematic configuration of the pixel 11 according to an example embodiment.

The pixel 11 includes the SPAD element 100, the clip transistor 200, the quench resistor 300, and the inverter 400. The clip transistor 200 may include a first transistor 200a and a second transistor 200b connected in series. Specifically, the clip transistor 200 may be formed by two transistors in which a drain of the first transistor 200a and a source of the second transistor 200b may be connected.

In FIG. 24, a connection point where the clip transistor 200 and the quench resistor 300 is connected by the junction of the pixel chip 500 and the logic chip 600 is indicated as the node N1. In addition, the boundary of the pixel chip 500 and the logic chip 600 is indicated by a broken line.

In the clip transistor 200, a first clip voltage HV1 may be supplied to a gate of the first transistor 200a and a second clip voltage HV2 may be supplied to a gate of the second transistor 200b. The clip transistor 200 may clip a source voltage of the first transistor 200a such that the source voltage of the first transistor 200a does not become below a predetermined value. That is, the clip transistor 200 may clip the voltage of the node N1, which is the connection point of the logic chip 600 and the pixel chip 500. The first transistor 200a and the second transistor 200b may be, for example, PMOS transistors.

The gates of the first transistor 200a and the second transistor 200b may be short-circuited with each other. In this case, the clip voltage HV may be commonly supplied to the gates of the first transistor 200a and the second transistor 200b. Hereinafter, for the sake of simplicity of the description, unless otherwise specified, the case where the gates of the first transistor 200a and the second transistor 200b may be short-circuited, the clip voltage HV may be commonly supplied to those gates will be described as an example.

When a photon is incident on the SPAD element 100 while the reverse bias voltage VSPAD higher than a breakdown voltage is applied to the SPAD element 100 through the quench resistor 300, an avalanche current may be generated in the SPAD element 100. The reverse bias voltage VSPAD may be a sum of the absolute value of the anode voltage VA and the absolute value of the cathode voltage VC. By the avalanche current flowing through the quench resistor 300, the voltage of the node N1 drops. When the voltage of the node N1 becomes lower than the threshold voltage of the PMOS transistor 400P of the inverter 400, the PMOS transistor 400P may conduct, so that the power source voltage VHV is output from the inverter 400 as the detection signal of a high level.

Thereafter, as the voltage of the node N1 continues to fall, a gate-source voltage of the first transistor 200a becomes a threshold value or less, so that the current does not flow through the first transistor 200a and the second transistor 200b, and the voltage of the node N1 may be clipped. In addition, the voltage applied to the SPAD element 100 becomes less than the breakdown voltage. Accordingly, the avalanche current does not flow, and the voltage of the node N1 increases. When the voltage of the node N1 becomes higher than the threshold voltage of the NMOS transistor 400N of the inverter 400, the NMOS transistor 400N conducts, so that a ground voltage may be output from the inverter 400 as the detection signal of a low level.

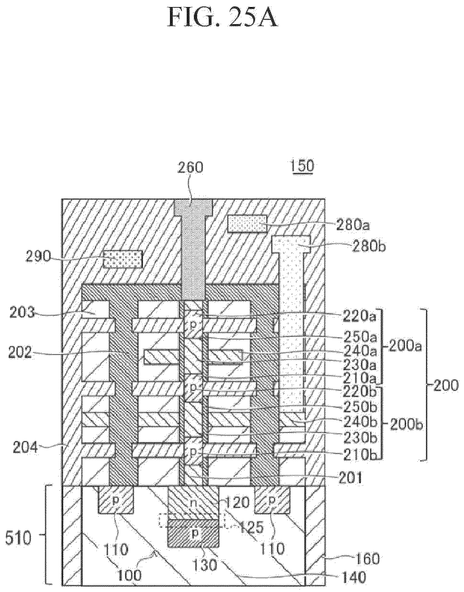

FIG. 25A is a cross-sectional view representing a structure of the unit element 150 according to an example embodiment.

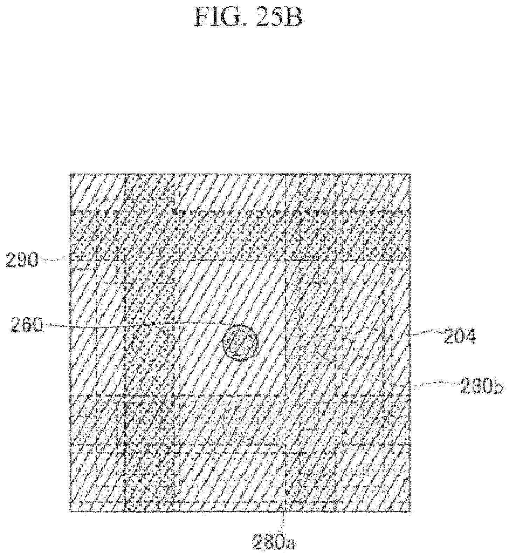

FIG. 25B is a plan view of the unit element 150 according to an example embodiment.

The unit element 150 may be formed in a plural quantity on the substrate 510 of the pixel chip 500. The substrate 510 may be, for example, a monocrystalline silicon substrate.

The P-type semiconductor layer 130 may be in contact with the cathode electrode layer 120. By bonding the P-type semiconductor layer 130 and the N-typed cathode electrode layer 120, PN junction of the SPAD element 100 may be formed. The PN junction may form the avalanche region 125, and function as an amplification region to accelerate the charges introduced into the P-type semiconductor layer 130 and generate the avalanche current.

The anode electrode layer 110 of the SPAD element 100 may be symmetrical to the cathode electrode layer 120, on the surface of the substrate 510 of the pixel chip 500.

The clip transistor 200 may be formed on the surface of the substrate 510. The clip transistor 200 may be formed by connecting the first transistor 200a and the second transistor 200b in series. The first transistor 200a and the second transistor 200b may be, for example, gate-all-around type MOS transistors. Specifically, the second transistor 200b may be a gate-all-around type PMOS transistor including a second pillar-shaped channel 230b formed by a portion of the pillar-shaped active pillar 201 having a first end connected to the cathode electrode layer 120 of the SPAD element 100, and a second planar gate 240b surrounding the second channel 230b. The first transistor 200a may be a gate-all-around type PMOS transistor including a first pillar-shaped channel 230a formed by another portion of the active pillar 201, and a first planar gate 240a surrounding the first channel 230a. The hybrid bump 260 may be connected to a second end of the active pillar 201.

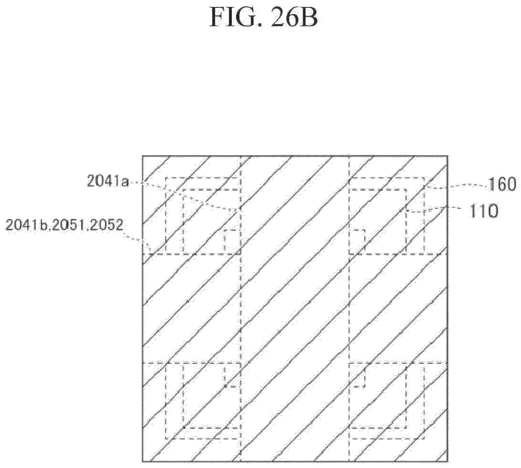

The first gate 240a of the first transistor 200a and the second gate 240b of the second transistor 200b may include at least one of polysilicon or metal. Here, the first gate 240a and the second gate 240b intersect (three-dimensionally) each other in a cross shape, when viewed in a plan view (see FIG. 26B).

Afirst end of the active pillar 201 may be connected to the cathode electrode layer 120 and may vertically overlap the center of the cathode electrode layer 120 on the surface of the substrate 510.

In the active pillar 201, a second source 220b and a second drain 210b may be formed on both sides of the second channel 230b of the second transistor 200b, respectively. In addition, a second gate oxide layer 250b may be formed on a surface of a region of the active pillar 201 where the second channel 230b of the second transistor 200b is formed. Accordingly, the second transistor 200b may be formed.

In the active pillar 201, a first source 220a and a first drain 210a may be formed on both sides of the first channel 230a of the first transistor 200a, respectively. In addition, a first gate oxide layer 250a may be formed on a surface of a region of the active pillar 201 where the first channel 230a of the first transistor 200a is formed. Accordingly, the first transistor 200a may be formed.

Therefore, the clip transistor 200 may include two transistors connected in series. The two transistors may include two parts of the pillar-shaped active pillar as channels of each of the two transistors. The pillar-shaped active pillar may have one end connected to the cathode of the SPAD element 100. Each channel of the two transistors may have a structure which is surrounded by two planar gates.

On the first transistor 200a, a first gate wire 280a, a second gate wire 280b, the anode wiring 290, and the hybrid bump 260 may be formed. The second gate wire 280b may be connected to the second gate 240b through a via. The first gate wire 280a may be connected to the first gate 240a through a via. The anode wiring 290 may be connected to the anode electrode layer 110 through a via. The anode wiring 290 may be a wire for supplying the anode voltage VA to the SPAD element 100. The first gate wire 280a may be a wire for supplying the first clip voltage HV1 to the first transistor 200a. The second gate wire 280b may be a wire for supplying the second clip voltage HV2 to the second transistor 200b.

The hybrid bump 260 may be bonded to a connection pad exposed on the surface of the logic chip 600 by metal bonding. Accordingly, the pixel chip 500 and the logic chip 600 may be bonded.

Each layer constituting the clip transistor 200, and each layer constituting the first gate wire 280a, the second gate wire 280b, the anode wiring 290, and the hybrid bump 260 insulated from each other by the interlayer insulation layer 203 and the insulation layer 204.

The column 202 of the insulation material may be provided around the pillar-shaped active pillar 201.

A manufacturing method of the unit element 150 according to an example embodiment will be described.

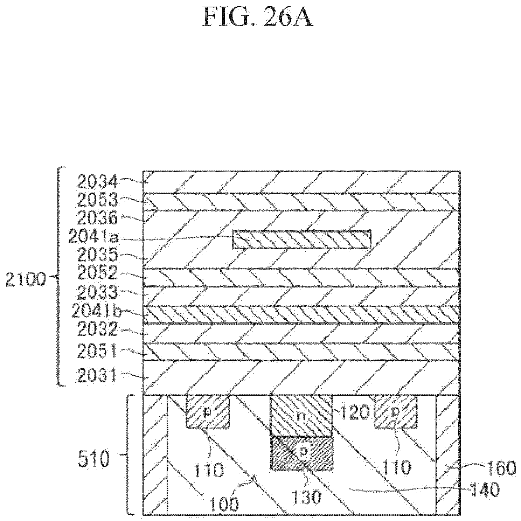

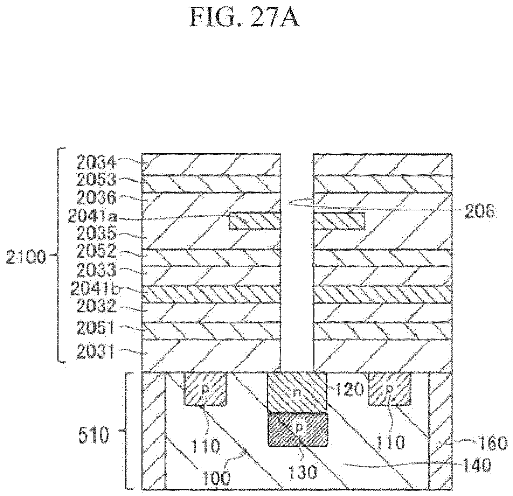

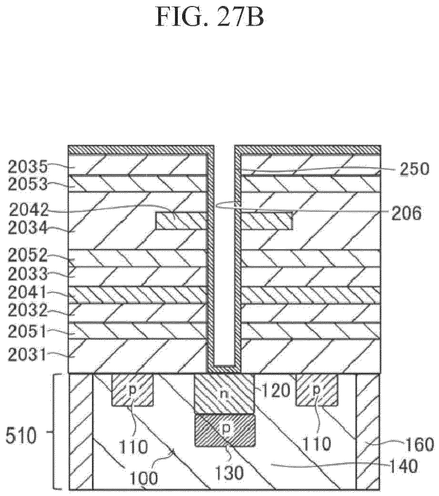

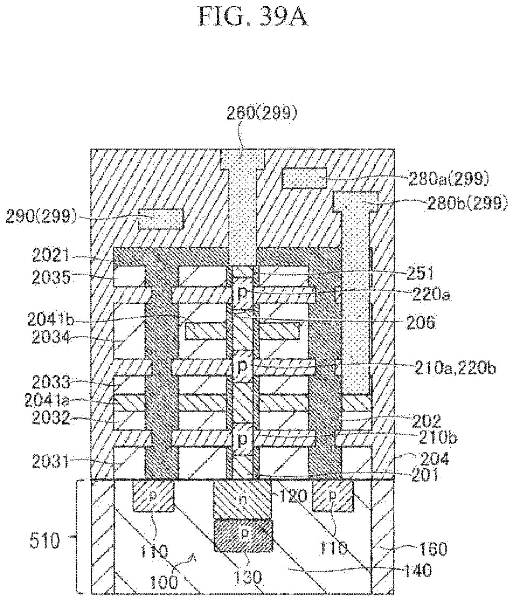

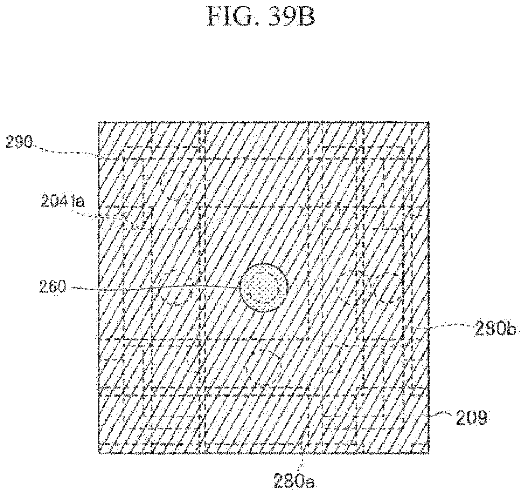

FIG. 26A to FIG. 39B are diagrams for explaining a manufacturing method of the unit element 150 according to an example embodiment. The drawings corresponding to "A" following each drawing number (i.e., FIG. 26A, FIG. 27A, ..., FIG. 39A) are drawings for explaining a manufacturing method of the unit element 150 by a cross-sectional view, and drawings corresponding to "B" following each drawing number (i.e., FIG. 26B, FIG. 27B, ..., FIG. 39B) are plan view drawings corresponding to the cross-sectional views.

As shown in FIG. 26A and FIG. 26B, the first sacrificial layer 2051, a second gate layer 2041b, the second sacrificial layer 2052, a first gate layer 2041a, and a third sacrificial layer 2053 may be formed on the substrate 510 of the pixel chip 500 where the SPAD element 100 is formed. More specifically, the laminated film 2100 may be formed by sequentially forming the first sacrificial layer 2051, the first interlayer insulation layer 2032, the second gate layer 2041b, the second interlayer insulation layer 2033, the second sacrificial layer 2052, a third interlayer insulation layer 2035, the first gate layer 2041a, a fourth interlayer insulation layer 2036, and the third sacrificial layer 2053, on the substrate 510. The laminated film 2100 may also include lowermost interlayer insulation layer 2031 formed below the first sacrificial layer 2051 and the uppermost interlayer insulation layer 2034 formed on the third sacrificial layer 2053. The first sacrificial layer 2051 to the third sacrificial layer 2053 may include silicon nitride (SiN). The first interlayer insulation layer 2032 to the fourth interlayer insulation layer 2036 may include silicon dioxide (SiO2). The gate layer 2041 may include at least one of polysilicon and metal. Here, the first gate layer 2041a and the second gate layer 2041b intersect (three-dimensionally) each other in a cross shape, when viewed in a plan view. This is to avoid interference with the first gate wire 280a, the second gate wire 280b that is formed later. The first sacrificial layer 2051, the first interlayer insulation layer 2032, the second gate layer 2041b, the second interlayer insulation layer 2033, and the second sacrificial layer 2052 may be formed, then patterned by anisotropic etching using a resist, and thereafter filled again by silicon dioxide (SiO2), thereby planarizing the surface. The first gate layer 2041a may be patterned by anisotropic etching by using a resist, and then filled again with silicon dioxide (SiO2), thereby planarizing the surface. The lowermost interlayer insulation layer 2031 and the uppermost interlayer insulation layer 2034 may include silicon dioxide (SiO2).

As shown in FIG. 27A and FIG. 27B, the first hole 206 penetrating the laminated film 2100 may be formed, the cathode electrode layer 120 may be exposed through the first hole 206. The first hole 206 may be formed by, for example, anisotropic etching.

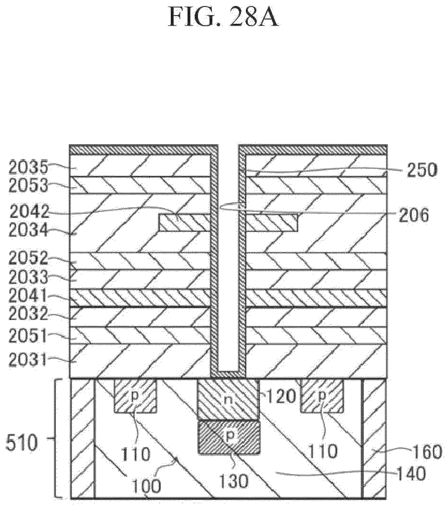

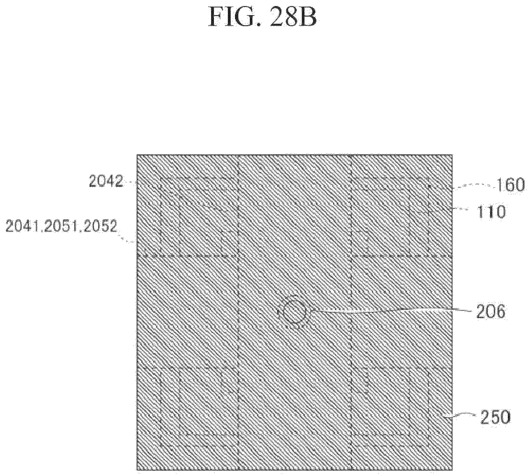

As shown in FIG. 28A and FIG. 28B, the gate oxide layer 250 may be formed on the side wall of the formed first hole 206. The gate oxide layer 250 may include silicon dioxide (SiO2).

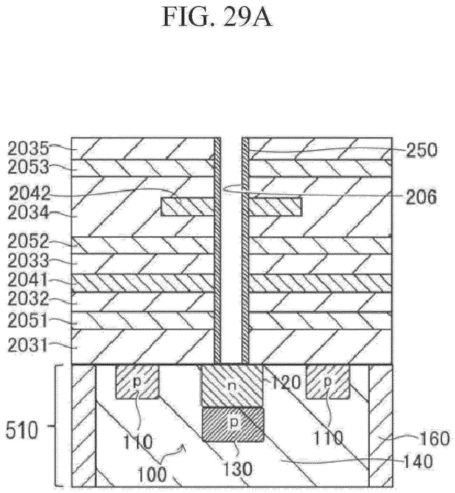

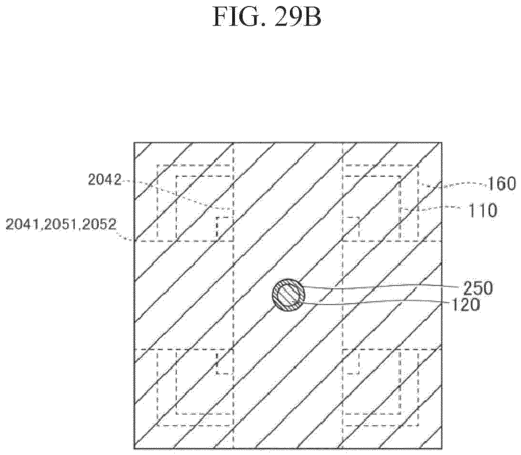

As shown in FIG. 29A and FIG. 29B, a portion of the gate oxide layer 250 in contact with the cathode electrode layer 120 at the bottom of the first hole 206, and a portion on the uppermost interlayer insulation layer 2034 may be removed by anisotropic etching. Accordingly, the cathode electrode layer 120 may be exposed.

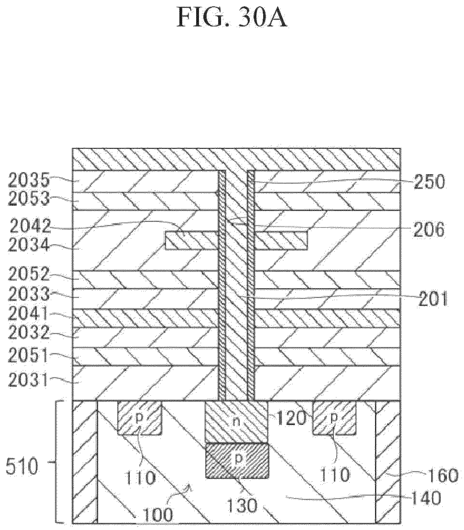

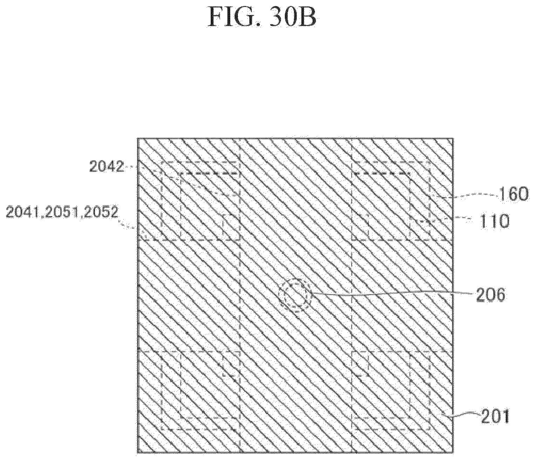

As shown in FIG. 30A and FIG. 30B, the pillar-shaped active pillar 201 may be formed within the first hole 206, to be connected to the cathode electrode layer 120 of the SPAD element 100. The active pillar 201 may include, for example, polysilicon.

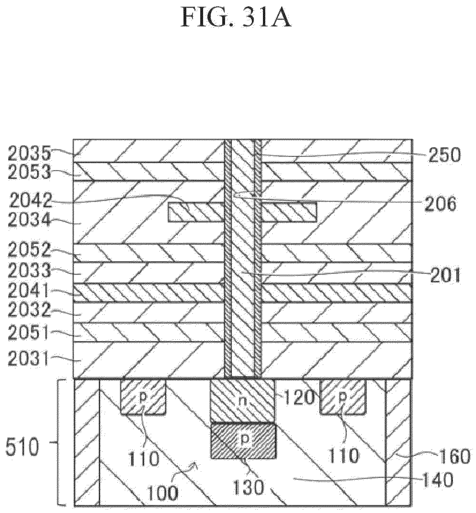

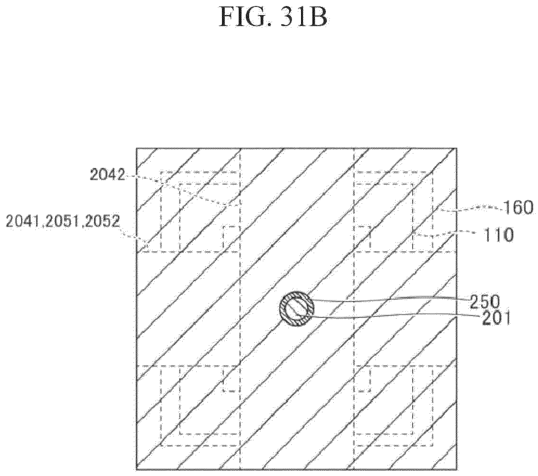

As shown in FIG. 31A and FIG. 31B, the portion of the active pillar 201 on the uppermost interlayer insulation layer 2034 may be removed. The portion of the active pillar 201 on the uppermost interlayer insulation layer 2034 may be removed by, for example, CMP.

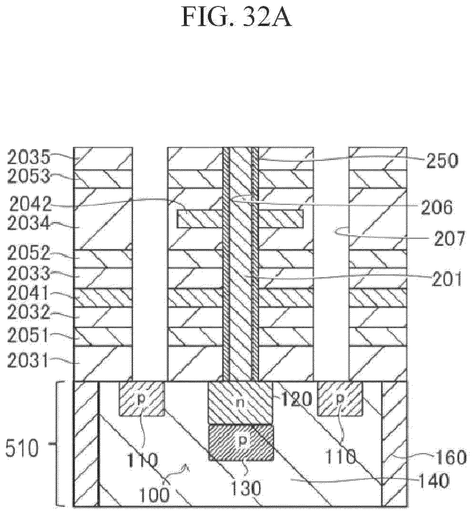

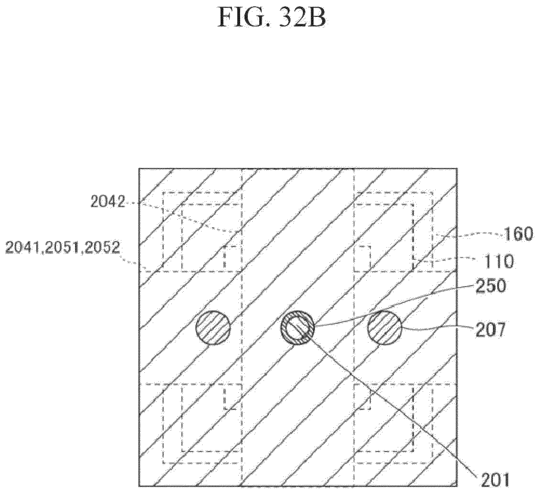

As shown in FIG. 32A and FIG. 32B, the second hole 207 penetrating the laminated film 2100 may be formed around the active pillar 201. For example, two second holes 207 may be formed, and the active pillar 201 may be provided between the two second holes 207. The second hole 207 may be formed by, for example, anisotropic etching.

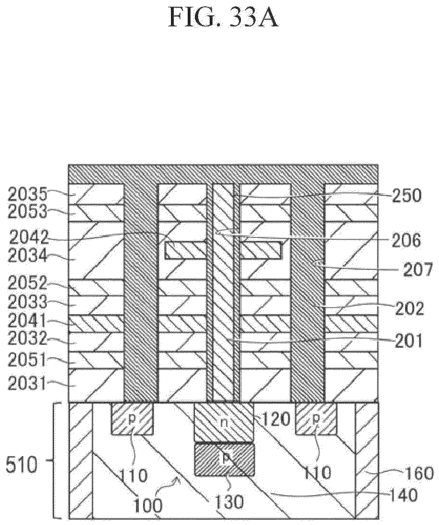

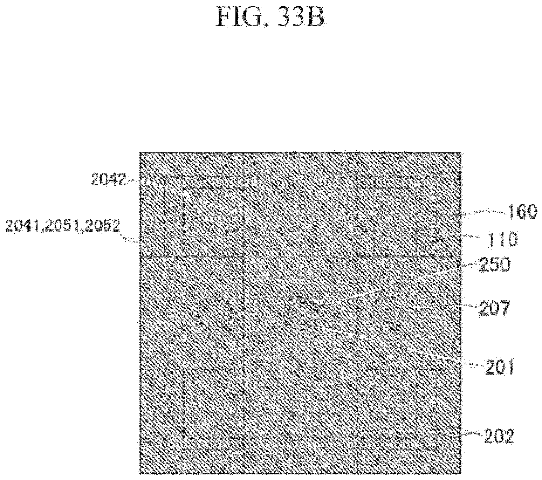

As shown in FIG. 33A and FIG. 33B, the column 202 of the insulation material may be formed by forming an insulation material in the second hole 207. For example, the insulation material may be formed by charging the insulation material into the second hole 207. The column 202 of the insulation material may include silicon dioxide (SiO2). The column 202 may increase structural stability of the laminated film 2100. Thus, by forming the column 202 of the insulation material, the laminated film 2100 may be prevented from being collapsed during the process of removing the first sacrificial layer 2051 to the third sacrificial layer 2053, to be described later.

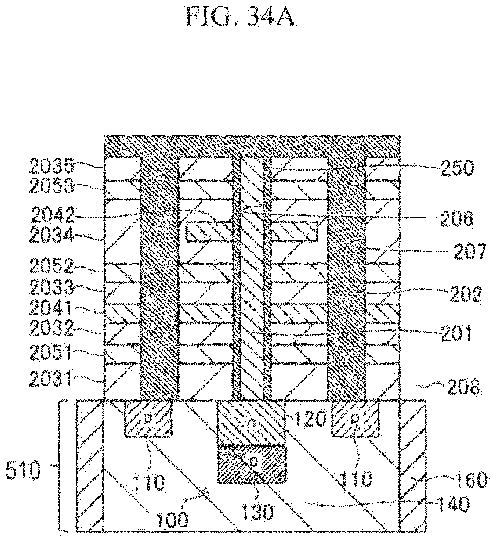

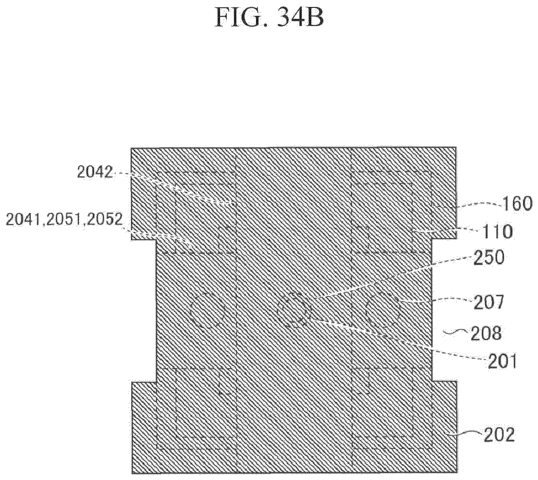

As shown in FIG. 34A and FIG. 34B, a trench 208 penetrating the laminated film 2100 may be formed for each SPAD element 100, such that a portion of the trench 208 overlaps with the pixel isolation layer 160 that separates the SPAD elements 100 from each other. The trench 208 may be formed by, for example, anisotropic etching.

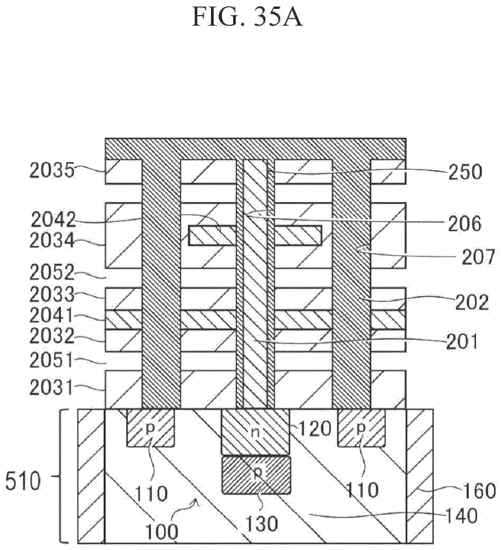

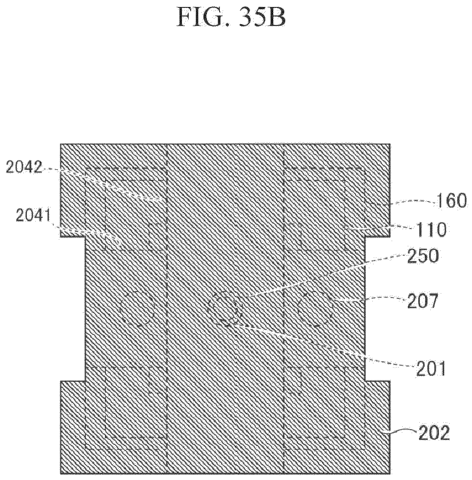

As shown in FIG. 35A and FIG. 35B, the first sacrificial layer 2051 to the third sacrificial layer 2053 may be removed to expose the gate oxide layer 250. The first sacrificial layer 2051 to the third sacrificial layer 2053 may be removed by wet etching with adjusted selectivity.

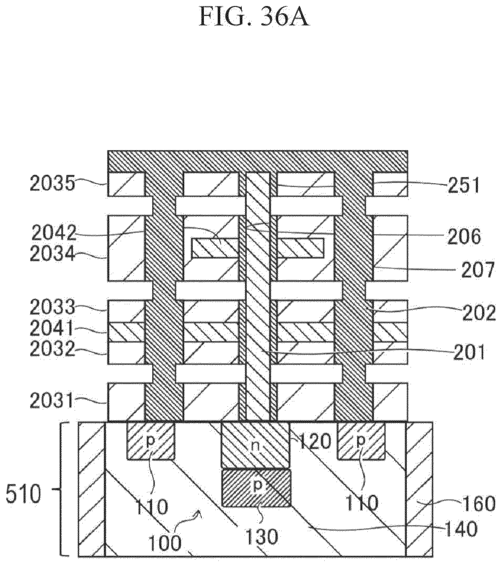

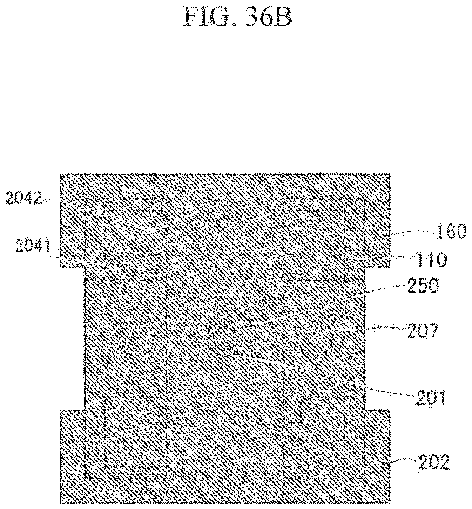

As shown in FIG. 36A and FIG. 36B, a portion of the exposed gate oxide layer 250 may be removed to expose a portion of the active pillar 201. The portion of the gate oxide layer 250 may be removed by wet etching with adjusted selectivity.

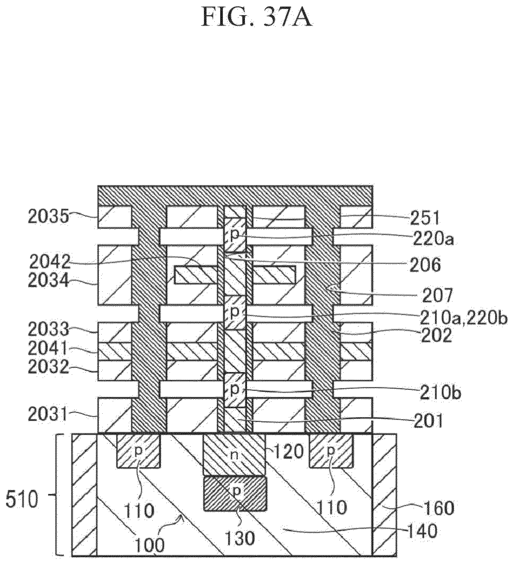

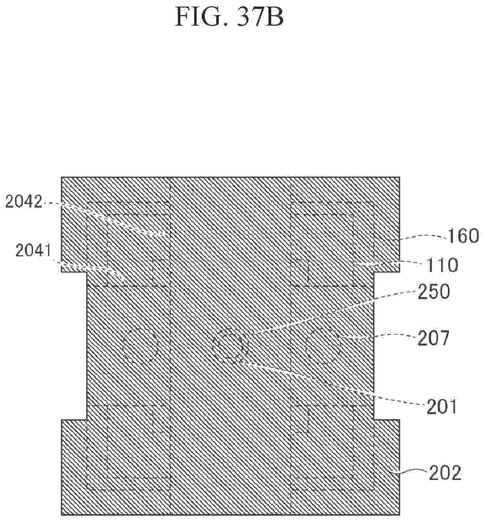

As shown in FIG. 37A and FIG. 37B, the diffusion layer may be formed on a portion of the exposed active pillar 201, the first source 220a and the first drain 210a of the first transistor 200a to form the second source 220b and the second drain 210b of the second transistor 200b. The first source 220a and the first drain 210a of the first transistor 200a, and the second source 220b and the second drain 210b of the second transistor 200b may be formed by plasma doping. The first drain 210a of the first transistor 200a, and the second source 220b of the second transistor 200b may be formed as a single common diffusion layer.

By doping an acceptor of a P-type impurity into the active pillar 201 by using the lowermost interlayer insulation layer 2031, the first interlayer insulation layer 2032, the second interlayer insulation layer 2033, the third interlayer insulation layer 2035, the fourth interlayer insulation layer 2036, and the uppermost interlayer insulation layer 2034 as a mask, the first source 220a and the first drain 210a of the first transistor 200a, and the second source 220b and the second drain 210b of the second transistor 200b may be formed by self-alignment. Accordingly, non-uniformity of characteristics of the clip transistor 200 may be reduced.

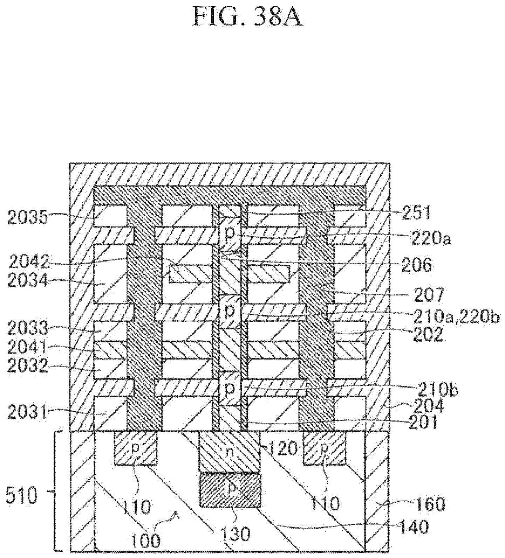

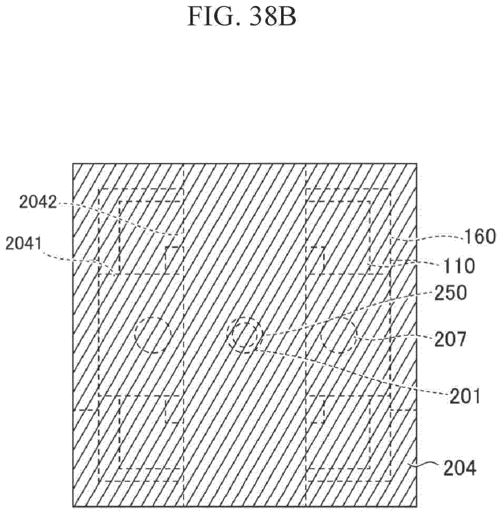

As shown in FIG. 38A and FIG. 38B, the trench 208 and spaces between the lowermost interlayer insulation layer 2031, the first interlayer insulation layer 2032, the second interlayer insulation layer 2033, the third interlayer insulation layer 2035, the fourth interlayer insulation layer 2036, and the uppermost interlayer insulation layer 2034 may be filled with the insulation layer 204. The insulation layer 204 may include silicon dioxide (SiO2).

As shown in FIG. 39A and FIG. 39B, in order to electrically connect the first gate wire 280a to the first gate layer 2041a, the second gate wire 280b may be formed to be electrically connected to the second gate layer 2041b. In addition, the wiring layer 299 including the anode wiring 290 and the hybrid bump 260 may be formed.

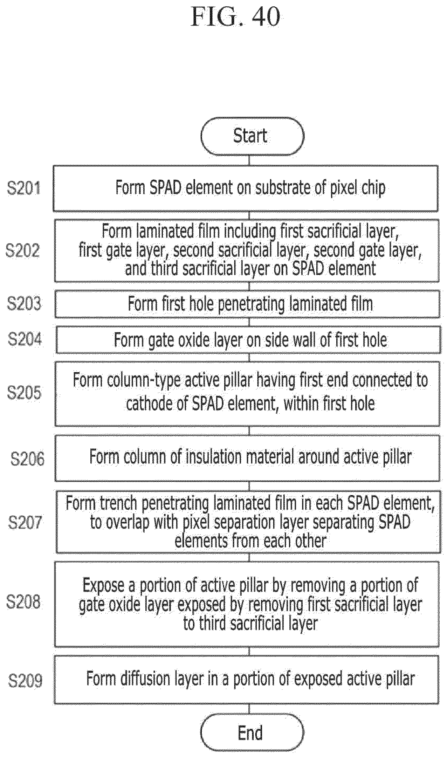

FIG. 40 is a flowchart representing a manufacturing method of the image sensor 1.

At operation S201, the SPAD element 100 may be formed on the substrate 510 of the pixel chip 500.

At operation S202, on the SPAD element 100, the laminated film 2100 including the first sacrificial layer 2051, the second gate layer 2041b, the second sacrificial layer 2052, the first gate layer 2041a, and the third sacrificial layer 2053 may be formed.

At operation S203, the first hole 206 penetrating the laminated film 2100 may be formed.

At operation S204, the gate oxide layer 250 may be formed on the side wall of the formed first hole 206.

At operation S205, within the first hole 206, the pillar-shaped active pillar 201 having a first end connected to the cathode electrode layer 120 of the SPAD element 100 may be formed.

At operation S206, a pillar of an insulation material may be formed around the active pillar 201.

At operation S207, a trench 208 penetrating the laminated film 2100 may be formed between each SPAD element 100 such that the trench 208 overlaps with the pixel isolation layer 160 that separates the SPAD elements 100 from each other.

At operation S208, a portion of the active pillar 201 may be exposed by removing a portion of the gate oxide layer 250 exposed by removing the first sacrificial layer 2051 and the second sacrificial layer 2052.

At operation S209, the first source 220a and a drain 201a of the first transistor 200a, and the second source 220b and the second drain 210b of the second transistor 200b may be formed, by forming the diffusion layer on a portion of the exposed active pillar 201.

One or more example embodiments provide an image sensor formed by a logic chip having a logic circuit and a pixel chip having an avalanche photodiode. A vertical gate-all-around type transistor is provided in the pixel chip. The vertical gate-all-around type transistor may include a planar gate and a channel including a portion of a pillar-shaped active pillar having a first end connected to a cathode of the avalanche photodiode provided in the pixel chip and having a second end connected to an electrode pad to be connected to the logic chip. Accordingly, low power consumption and small area of the image sensor may be realized.

The threshold voltage of the transistor of the logic circuit may be lower than a threshold voltage of the gate-all-around type transistor. Accordingly, low power consumption of the image sensor may be realized.

The avalanche photodiode may be formed on the substrate of the pixel chip, and the anode may be symmetrical to the cathode, on the surface of the substrate. The first end of the pillar-shaped active pillar may be connected to the cathode and may overlap a center of the cathode, on the surface of the substrate. Accordingly, small area of the image sensor may be realized.

The gate-all-around type transistor gate may include at least one of polysilicon and metal, which may function as a reflector.

A pillar of an insulation material may be provided around the pillar-shaped active pillar. Accordingly, structural integrity may be improved and the possibility of collapse of the laminated film during the manufacturing of the image sensor may be reduced.

The gate-all-around type transistor may be formed as a clip transistor configured to clip a voltage of a connection point of the logic chip and the pixel chip. Accordingly, power consumption of the logic chip may be reduced.

The gate-all-around type transistor may include two transistors connected in series. The two transistors may include two parts of the pillar-shaped active pillar as channels of each of the two transistors. The pillar-shaped active pillar may have one end connected to the cathode of the avalanche photodiode. Each channel of the two transistors may have a structure in which each is surrounded by two planar gates. Accordingly, the power consumption of the image sensor may be further reduced.

The laminated film having the first sacrificial layer, the gate layer, and the second sacrificial layer may be formed on the substrate of the pixel chip having the avalanche photodiode on its surface. After forming a hole penetrating the laminated film and forming the gate oxide layer on the side wall of the formed hole, the pillar-shaped active pillar may be formed within the hole, to be connected to the cathode of the avalanche photodiode. By removing a portion of the gate oxide layer, which may be exposed by removing the first sacrificial layer and the second sacrificial layer, a portion of the active pillar may be exposed. By forming a diffusion layer on a portion of the exposed active pillar, a vertical gate-all-around type transistor which includes a channel formed by a portion of the pillar-shaped active pillar having a first end connected to the cathode and a planar gate surrounding the channel may be formed. Accordingly, non-uniformity of characteristics of the vertical gate-all-around type transistor may be reduced, and uniformity of the image sensor may be increased.

A trench may be formed for each avalanche photodiode penetrating the laminated film such that at least a portion of the trench overlaps the pixel separation layer separating the avalanche photodiodes from each other. In addition, by using a trench, the first sacrificial layer, the second sacrificial layer, and a portion of the gate oxide layer may be removed, and by using the trench, a source and a drain may be formed by performing plasma doping and solid-state diffusion on a portion the channel. Accordingly, the vertical gate-all-around type transistor having a smaller characteristic non-uniformity may be formed.

In addition, before removing the first sacrificial layer and the second sacrificial layer, a pillar of an insulation material may be formed around the pillar-shaped channel. Accordingly, structural integrity may be improved and the possibility of collapse of the laminated film during the manufacturing of the image sensor may be reduced.

The laminated film having the first sacrificial layer, the second gate layer, the second sacrificial layer, the first gate layer, and the third sacrificial layer may be formed. By removing three portions of the gate oxide layer exposed by removing the first sacrificial layer, the second sacrificial layer, and the third sacrificial layer, three portions of the active pillar may be exposed. In addition, by forming a diffusion layer on three parts of the exposed active pillar, the vertical gate all-around transistor may be formed. The vertical gate all-around transistor may include two transistors connected in series. The two transistors may include two parts of the pillar-shaped active pillar as channels of each of the two transistors. The pillar-shaped active pillar may have one end connected to the cathode. Each channel of the two transistors may be surrounded by two planar gates, respectively. Accordingly, the power consumption of the image sensor may be further reduced.

## Claims

1. An image sensor (1), comprising:
a logic chip (600) comprising a logic circuit (400) configured to process a signal; and
a pixel chip (150, 500) configured to generate the signal, the pixel chip (150, 500) comprising:
an avalanche photodiode (100);
an electrode pad (260);
an active pillar (201) having a first end connected to a cathode (120) of the avalanche photodiode (100) and a second end connected to the electrode pad (260); and
a vertical gate-all-around transistor (200) having a channel (230) comprising a portion of the active pillar (201) and a planar gate (240) surrounding the channel (230),
wherein the logic chip (600) and the pixel chip (150, 500) are connected through the electrode pad (260).

2. The image sensor (1) of claim 1, wherein a threshold voltage of a transistor (400N, 400P) of the logic circuit is lower than a threshold voltage of the vertical gate-all-around transistor (200).

3. The image sensor (1) of claim 1 or 2, wherein the avalanche photodiode (100) is provided on a substrate (510) of the pixel chip (150, 500),
wherein an anode of the avalanche photodiode (100) is symmetrical to the cathode (120), on a surface of the substrate (510), and
wherein the first end of the active pillar (201) is connected to the cathode (120) and overlaps a center of the cathode (120) along a vertical direction.

4. The image sensor (1) of any one of the previous claims, wherein the planar gate (240) comprises polysilicon.

5. The image sensor (1) of any one of the previous claims, wherein the planar gate (240) comprises metal.

6. The image sensor (1) of any one of the previous claims, further comprising a pillar comprising an insulation material provided around the active pillar (201).

7. The image sensor (1) of any one of the previous claims, wherein the vertical gate-all-around transistor (200) is a clip transistor (200) configured to clip a voltage of a connection point (N1) of the logic chip (600) and the pixel chip (150, 500).

8. A manufacturing method of an image sensor (1), comprising:
providing (S201) a pixel chip (150, 500) comprising a substrate (510) and an avalanche photodiode (100);
forming (S202) a laminated film (2100) comprising a first sacrificial layer (2051), a gate layer (2041), and a second sacrificial layer (2052), on the substrate (510) of the pixel chip (150, 500);
forming (S203) a hole (206) penetrating the laminated film (2100) to expose a cathode (120) of the avalanche photodiode (100);
forming (S204) a gate oxide layer (250) on a side wall of the hole (206);
forming (S205) an active pillar (201) within the hole (206) that is connected to the cathode (120) of the avalanche photodiode (100);
removing (S208) the first sacrificial layer (2051) and the second sacrificial layer (2052) to expose a portion of the gate oxide layer (250);
exposing (S208) a portion of the active pillar (201) by removing the portion of the gate oxide layer (250); and
forming (S209) a diffusion layer on the portion of the active pillar (201) to form a vertical gate-all-around transistor (200) having a channel (230) comprising a portion of the active pillar (201) and a planar gate (240) surrounding the channel (230), the active pillar (201) having a first end connected to the cathode (120).

9. The manufacturing method of claim 8, wherein the forming the laminated film (2100) comprises sequentially forming the first sacrificial layer (2051), a first interlayer insulation layer (2032), the gate layer (2041), a second interlayer insulation layer (2033), the second sacrificial layer (2052), and a third interlayer insulation layer (2035).

10. The manufacturing method of claim 8 or 9, further comprising performing plasma doping or solid-state diffusion on the portion of the active pillar (201) to form a source (220) and a drain (210) of the vertical gate-all-around transistor (200).

11. The manufacturing method of claim 10, further comprising forming a trench (208) penetrating the laminated film (2100),
wherein, the exposing the portion of the active pillar (201) comprises removing the first sacrificial layer (2051), the second sacrificial layer (2052), and a portion of the gate oxide layer (250) through the trench (208), and
wherein the forming the source (220) and the drain (210) comprises performing the plasma doping and the solid-state diffusion on a portion of the channel (230) through the trench (208).

12. The manufacturing method of any one of claims 8 to 11, wherein the exposing the portion of the active pillar (201) comprises forming a pillar of an insulation material around the channel (230) before removing the first sacrificial layer (2051) and the second sacrificial layer (2052).

13. The manufacturing method of any one of claims 8 to 12, wherein the forming the laminated film (2100) comprises forming the first sacrificial layer (2051), a second gate layer (2041b), the second sacrificial layer (2052), a first gate layer (2041a), and a third sacrificial layer (2053),
wherein the exposing the portion of the active pillar (201) comprises removing three portions of the gate oxide layer (250) exposed by removing the first sacrificial layer (2051), the second sacrificial layer (2052), and the third sacrificial layer (2053), three portions of the active pillar (201),
wherein the forming the vertical gate-all-around transistor (200) comprises forming two transistors (200a, 200b) connected in series by forming the diffusion layer on the three portions of the active pillar (201), and
wherein the two transistors (200a, 200b) comprise two parts of the active pillar (201) having as channels (230) of each of the two transistors (200a, 200b), and each of the two transistors (200a, 200b) is surrounded by two planar gates (240) of the two transistors (200a, 200b), respectively.
